# EUROPEAN PATENT APPLICATION

(11) **EP 4 794 467 A1**
(43) Date of publication of application: **19.08.2026**
(21) Application number: 26153050.5
(22) Date of filing: 20.01.2026
(51) Int. Cl.: H10B 12/00, H10D 30/67

(54) **SEMICONDUCTOR MEMORY DEVICE**

(30) Priority: 14.02.2025 KR 20250019115
(71) Applicant: Samsung Electronics Co., Ltd., Suwon-si, Gyeonggi-do 16677 (KR)
(72) Inventor: CHOI, Jae Hyun, 16677 Suwon-si (KR); JEONG, Moon Young, 16677 Suwon-si (KR)
(74) Representative: Marks & Clerk LLP

(57) **Abstract**

An example of a semiconductor memory device includes a substrate; bitlines extending in a first direction on the substrate; first back gate lines extending in a second direction; first semiconductor patterns connected to the bitlines and extending in a third direction, on the first back gate lines; wordlines extending in the second direction on the first semiconductor patterns; second semiconductor patterns connected to the bitlines and extending in the third direction, on the wordlines; and second back gate lines extending in the second direction on the second semiconductor patterns.

## Description

### BACKGROUND

To meet consumer demands for excellent performance and low cost, increasing the integration density of semiconductor memory devices may be required. Since the integration density of a semiconductor memory device may determine a product cost, achieving higher integration density is particularly important.

For two-dimensional (2D) or planar semiconductor memory devices, integration density primarily depends on the area occupied by a unit memory cell and is therefore significantly affected by the level of fine patterning technology. However, since expensive equipment is used to achieve finer patterns, the integration density of 2D semiconductor memory devices may be limited.

### SUMMARY

The present disclosure relates to a semiconductor memory device with improved integration density.

An objective of the present disclosure is to provide a semiconductor memory device including a plurality of memory cells.

The objectives of the present disclosure are not limited to those mentioned above, and other objectives not explicitly stated will be clearly understood by those skilled in the art based on the following description.

According to an aspect of the present disclosure, a semiconductor memory device includes a substrate; bitlines extending in a first direction on the substrate; first back gate lines extending in a second direction; first semiconductor patterns connected to the bitlines and extending in a third direction, on the first back gate lines; wordlines extending in the second direction on the first semiconductor patterns; second semiconductor patterns connected to the bitlines and extending in the third direction, on the wordlines; and second back gate lines extending in the second direction on the second semiconductor patterns.

According to the aforementioned and other implementations of the present disclosure, a semiconductor memory device includes a substrate; first back gate lines and second back gate lines alternately arranged in a first direction on the substrate to be spaced apart; wordlines, each positioned between first and second back gate lines adjacent in the first direction; bitlines extending in the first direction on the substrate; first semiconductor patterns connected to the bitlines, and each positioned between a first back gate line and a wordline adjacent in the first direction; storage nodes connected to the first semiconductor patterns; and second semiconductor patterns connected to the bitlines, and each positioned between a wordline and a second back gate line adjacent in the first direction.

According to the aforementioned and other implementations of the present disclosure, a semiconductor memory device includes a substrate; first back gate lines and second back gate lines alternately arranged in the first direction on the substrate to be spaced apart, and extending in a second direction; wordlines extending in the second direction, and each positioned between a first back gate line and a second back gate line adjacent in the first direction; bitlines extending in the first direction and spaced apart in the second direction on the substrate; first semiconductor patterns connected to the respective bitlines, each positioned between a first back gate line and a wordline adjacent in the first direction, and extending in a third direction; and second semiconductor patterns connected to the respective bitlines, each positioned between a wordline and a second back gate line adjacent in the first direction, and extending in the third direction, wherein the first, second, and third directions intersect each other, and one of the first, second, and third directions is perpendicular to an upper surface of the substrate.

At least some of the above and other features of the invention are set out in the claims.

It should be noted that the effects of the present disclosure are not limited to those described above, and other effects of the present disclosure will be apparent from the following description.

### BRIEF DESCRIPTION OF THE DRAWINGS

The above and other aspects and features of the present disclosure will become more apparent by describing example implementations thereof in detail with reference to the attached drawings, in which:
FIG. 1 is an example circuit diagram of a semiconductor memory device according to some implementations;
FIGS. 2A and 2B are diagrams for explaining the write operation of a memory cell in FIG. 1;
FIGS. 3A and 3B are diagrams for explaining the read operation of a memory cell in FIG. 1;
FIG. 4 is an example perspective view of a semiconductor memory device according to some implementations;
FIG. 5 is an example perspective view of a semiconductor memory device according to some implementations;
FIG. 6 is an example cross-sectional view of the semiconductor memory device in FIG. 5;
FIG. 7 is an example perspective view of a semiconductor memory device according to some implementations;
FIG. 8 is an example perspective view of a semiconductor memory device according to some implementations;
FIG. 9 is an example perspective view of a semiconductor memory device according to some implementations;
FIG. 10 is an example cross-sectional view of the semiconductor memory device in FIG. 9;
FIG. 11 is an example perspective view of a semiconductor memory device according to some implementations;
FIGS. 12 and 13 are example perspective views of a semiconductor memory device according to some implementations;
FIGS. 14A, 15A, 16A, 17A, 18A, 19A, 20A, 21A, 22A, 23A, 24A, 25A, 26A, and 27A are plan views for explaining a manufacturing method of a semiconductor memory device according to some implementations;
FIGS. 14B, 15B, 16B, 17B, 18B, 19B, 20B, 21B, 22B, 23B, 24B, 25B, 26B, and 27B are cross-sectional views taken along lines A-A' of FIGS. 14A, 15A, 16A, 17A, 18A, 19A, 20A, 21A, 22A, 23A, 24A, 25A, 26A, and 27A, respectively;
FIG. 28A is a plan view for explaining a manufacturing method of a semiconductor memory device according to some implementations;
FIG. 28B is a cross-sectional view taken along line A-A' of FIG. 28A;
FIGS. 29A, 30A and 31A are plan views for explaining a manufacturing method of a semiconductor memory device according to some implementations;
FIGS. 29B, 30B and 31B are cross-sectional views taken along lines A-A' of FIGS. 29A, 30A, and 31A, respectively; and
FIG. 32 is a diagram for explaining the operation of a semiconductor memory device according to some implementations.

### DETAILED DESCRIPTION

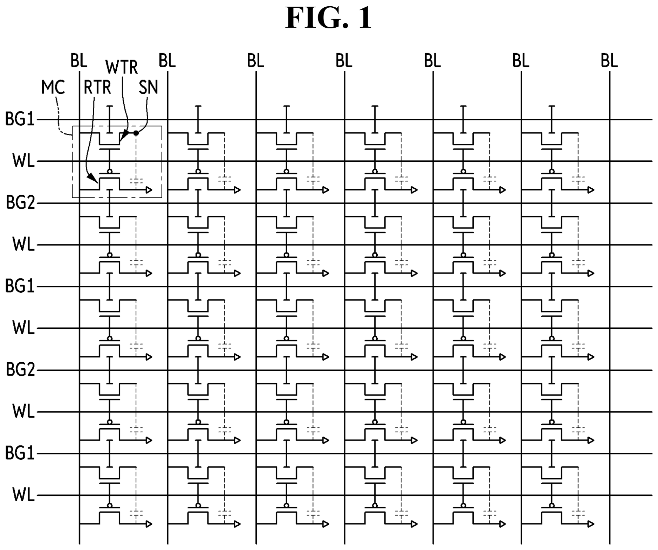

FIG. 1 is an example circuit diagram of a semiconductor memory device according to some implementations.

Referring to FIG. 1, the semiconductor memory device according to some implementations may include a plurality of memory cells MC. The memory cells MC may be arranged in a two-dimensional (2D) or three-dimensional (3D) manner.

A plurality of bitlines BL may extend in a first direction DR1 and may be arranged along a second direction DR2. A plurality of wordlines WL may extend in the second direction DR2 and may be spaced apart in the first direction DR1. One memory cell MC may be positioned between one wordline WL and one bitline BL.

One back gate line (e.g., one first or second back gate line BG1 or BG2) may be positioned between two adjacent wordlines WL. First back gate lines BG1 and second back gate lines BG2 may be alternately arranged along the first direction DR1. Two adjacent wordlines WL may share one first or second back gate line BG1 or BG2. Two memory cells MC that are connected to the same bitline BL and are adjacent to each other in the first direction DR1 may share one back gate line (e.g., one first or second back gate line BG1 or BG2).

Each of the memory cells MC may include a write transistor WTR and a read transistor RTR. The read transistor RTR and the write transistor WTR of one memory cell MC may share one wordline WL and one bitline BL. Here, the write transistor WTR and the read transistor RTR may be transistors of different conductivity types. For example, the write transistor WTR may be a first conductivity type (e.g, n-type) transistor, and the read transistor RTR may be a second conductivity type (e.g., p-type) transistor. For example, the write transistor WTR may be an n-type metal-oxide semiconductor (NMOS) transistor, and the read transistor RTR may be a p-type metal-oxide semiconductor (PMOS) transistor.

Write transistors WTR may be connected between storage nodes SN and the bitlines BL. The gate terminals of the write transistors WTR may be connected to the wordlines WL, the first source/drain terminals of the write transistors WTR may be connected to the storage nodes SN, and the second source/drain terminals of the write transistors WTR may be connected to the bitlines BL.

Read transistors RTR may be connected between a ground line and the bitlines BL. The gate terminals of the read transistors RTR may be connected to the wordlines WL, the first source/drain terminals of the read transistors RTR may be connected to the bitlines BL, and the second source/drain terminals of the read transistors RTR may be connected to the ground line.

The first back gate lines BG1 or the second back gate lines BG2 may be provided for the write transistors WTR or the read transistors RTR. For example, in the first row, the first back gate lines BG1 may be provided for the write transistors WTR, and the second back gate lines BG2 may be provided for the read transistors RTR.

In the semiconductor memory device according to some implementations, by adjusting the voltage (e.g., a negative voltage) applied to the first back gate lines BG1 and the voltage (e.g., a positive voltage) applied to the second back gate lines BG2, the off-current flowing through the write transistors WTR and the read transistors RTR in a standby state when the semiconductor memory device according to some implementations is not performing a read or write operation may be reduced. Additionally, in the standby state of the semiconductor memory device according to some implementations, the off-current flowing through the write transistor WTR may not vary depending on the state of the storage nodes SN (whether logic high or logic low). Accordingly, it is possible to prevent or reduce power consumption in the semiconductor memory device caused by variations in the off-current of the write transistors WTR depending on the state of the storage nodes SN. Furthermore, the semiconductor memory device according to some implementations may maintain a stable standby state.

A semiconductor memory device including the memory cells MC may also be referred to as a two-transistor-zero-capacitor (2T-0C) memory device. The semiconductor memory device may be a dynamic random access memory (DRAM) device. The semiconductor memory device according to some implementations may not include a separate capacitor for charge storage. For instance, the semiconductor memory device may make use of the inherent capacitance between the storage node SN and ground line to store charge at the storage node SN. Accordingly, the area required for forming a capacitor may be reduced, enabling higher integration of a semiconductor memory device and reducing the manufacturing cost.

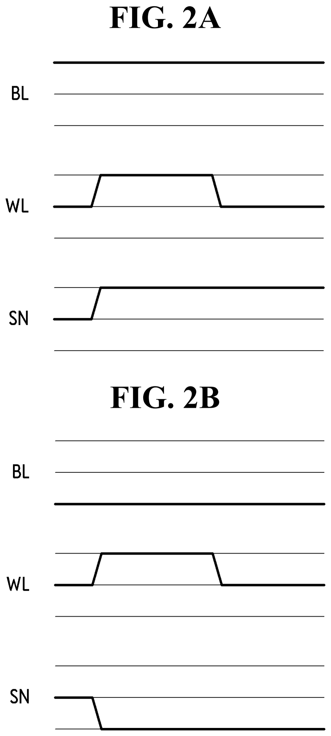

FIGS. 2A and 2B are diagrams for explaining the write operation of a memory cell in FIG. 1.

Referring to FIGS. 1 and 2A, a logic high voltage may be applied to a bitline BL. When a logic high voltage is applied to a wordline WL, a write transistor WTR may be turned on, and a read transistor RTR may be turned off. Accordingly, an electrical signal (or charge) from the bitline BL may be transferred (or charged) to a storage node SN, causing the storage node SN to become logic high. In this state, a data value of 1 may be written to the memory cell MC.

Referring to FIGS. 1 and 2B, a logic low voltage may be applied to the bitline BL. When a logic high voltage is applied to the wordline WL, the write transistor WTR may be turned on, and the read transistor RTR may be turned off. Accordingly, the storage node SN may become logic low, and a data value of 0 may be written to the memory cell MC.

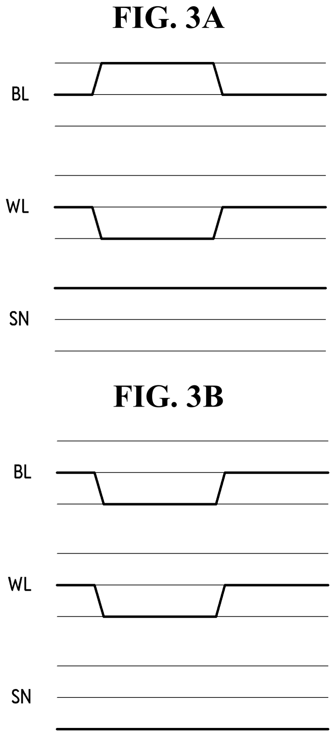

FIGS. 3A and 3B are diagrams for explaining the read operation of a memory cell in FIG. 1.

Referring to FIGS. 1 and 3A, a storage node SN may be in a logic high state. When a logic low voltage is applied to a wordline WL, a read transistor RTR may be turned on, and a write transistor WTR may be turned off. Accordingly, the electrical signal stored in the storage node SN may be read through the current flowing in the bitline BL. A logic high voltage may be applied to the bitline BL, and the data value of 1 stored in the memory cell MC may be read. The storage node SN may maintain its logic high state even after the read operation. That is, the memory cell MC may retain data even after the read operation.

Referring to FIGS. 1 and 3B, the storage node SN may be in a logic low state. When a logic low voltage is applied to the wordline WL, the read transistor RTR may be turned on, and the write transistor WTR may be turned off. Accordingly, the electrical signal stored in the storage node SN may be read through the current flowing in the bitline BL. A logic low voltage may be applied to the bitline BL, and the data value of 0 stored in the memory cell MC may be read. The storage node SN may maintain its logic low state even after the read operation. That is, the memory cell MC may retain data even after the read operation.

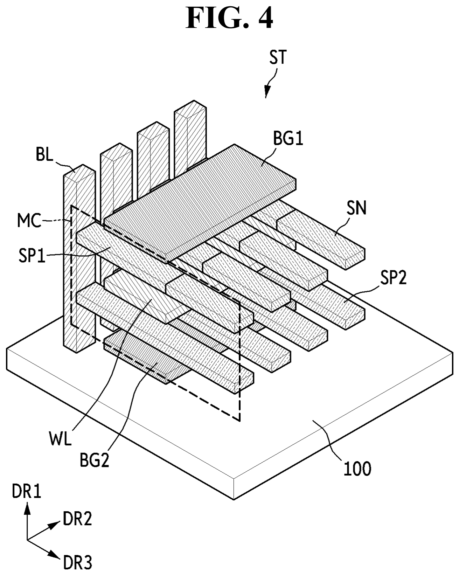

FIG. 4 is an example perspective view of a semiconductor memory device according to some implementations.

Referring to FIG. 4, the semiconductor memory device according to some implementations may include a substrate 100 and a stack structure ST.

In one example, the substrate 100 may be a silicon substrate or may include other materials, such as silicon germanium, indium antimonide, a lead telluride compound, indium arsenide, indium phosphide, gallium arsenide, or gallium antimonide. In another example, the substrate 100 may include a ceramic substrate, a quartz substrate, or a glass substrate. In yet another example, the substrate 100 may include a flexible plastic substrate such as polyimide, polyethylene terephthalate (PET), polyethylene naphthalate (PEN), polymethyl methacrylate (PMMA), polycarbonate (PC), polyethersulfone (PES), or polyester.

The stack structure ST may be positioned on the substrate 100. The surface of the substrate 100 where the stack structure ST is positioned may be referred to as the upper surface of the substrate 100. The stack structure ST may include a plurality of memory cells MC arranged in a second direction DR2. The stack structure ST may include bitlines BL, first semiconductor patterns SP1, second semiconductor patterns SP2, wordlines WL, a first back gate line BG1, and a second back gate line BG2.

The bitlines BL may be positioned on the substrate 100. The bitlines BL may extend in a first direction DR1. The bitlines BL may be spaced apart in the second direction DR2.

The bitlines BL may include a conductive material. For example, the bitlines BL may include at least one of a doped semiconductor material, a conductive metal nitride, a conductive metal silicon nitride, a metal carbonitride, a conductive metal silicide, a conductive metal oxide, a 2D material, or a metal. The bitlines BL are illustrated as single layers, but are not limited thereto.

In the semiconductor memory device according to some implementations, the 2D material may be a metallic material and/or a semiconductor material. The 2D material may include a 2D allotrope or a 2D compound and may include, for example, graphene, molybdenum disulfide (MoS₂), molybdenum diselenide (MoSe₂), tungsten diselenide (WSe₂), tungsten disulfide (WS₂), or a combination thereof, but the present disclosure is not limited thereto. That is, the above-mentioned 2D materials are merely examples, and the 2D material that may be included in the semiconductor memory device according to some implementations are not particularly limited.

The first semiconductor patterns SP1 may be positioned on the substrate 100. The first semiconductor patterns SP1 may extend in a third direction DR3. At the same height from the substrate 100, the first semiconductor patterns SP1 may be spaced apart in the second direction DR2.

Each of the first semiconductor patterns SP1 may include a first source/drain region, a second source/drain region, and a channel region between the first and second source/drain regions. Each source/drain region may be either a source or a drain, depending on the doping characteristics of the respective transistor. The first and second source/drain regions may be positioned at opposite ends of the corresponding first semiconductor pattern SP1 in the third direction DR3. The first source/drain regions, the channel regions, and the second source/drain regions of the first semiconductor patterns SP1 may serve as the first source/drain terminals, the channel regions, and the second source/drain terminals, respectively, of the write transistors WTR in FIG. 1. The first source/drain regions and second source/drain regions of the first semiconductor patterns SP1 may include n-type impurities such as arsenic (As) or phosphorus (P).

The first semiconductor patterns SP1 may be electrically connected to respective storage nodes SN. The storage nodes SN may be positioned on (e.g., adjacent to) the first source/drain regions of the first semiconductor patterns SP1. The first semiconductor patterns SP1 may be in contact with the storage nodes SN.

For example, the storage nodes SN may include the same material as the second semiconductor patterns SP2. In another example, the storage nodes SN may include a conductive material. The storage nodes SN may include at least one of a doped semiconductor material, a conductive metal nitride, a conductive metal silicon nitride, a metal carbonitride, a conductive metal silicide, a conductive metal oxide, a two-dimensional material, or a metal. The storage nodes SN are illustrated as single layers, but are not limited thereto.

The second source/drain regions of the first semiconductor patterns SP1 may be electrically connected to the respective bitlines BL. The second source/drain regions of the first semiconductor patterns SP1 may be in contact with the bitlines BL.

For example, the first semiconductor patterns SP1 may include a semiconductor material. The first semiconductor patterns SP1 may include at least one of silicon, silicon germanium, or polysilicon, but are not limited thereto. In some implementations, the first semiconductor patterns SP1 may include epitaxial silicon. Epitaxial silicon may be silicon that has been formed through an epitaxial growth process. It may have a higher purity and lower defect density than silicon formed through other methods, such as the Czochralski (CZ) method.

The first semiconductor patterns SP1 may each include an oxide semiconductor material. The first semiconductor patterns SP1 may include, for example, a metal oxide. In one example, the first semiconductor patterns SP1 may each include an amorphous metal oxide film. In another example, the first semiconductor patterns SP1 may each include a polycrystalline metal oxide film. In yet another example, the first semiconductor patterns SP1 may each include a combination of an amorphous metal oxide film and a polycrystalline metal oxide film. In still another example, the first semiconductor patterns SP1 may each include a c-axis aligned crystalline (CAAC) metal oxide film.

For example, the first semiconductor patterns SP1 may each include one of indium oxide, tin oxide, zinc oxide, an In-Zn-based oxide, an Sn-Zn-based oxide, an Al-Zn-based oxide, a Zn-Mg-based oxide, an Sn-Mg-based oxide, an In-Mg-based oxide, an In-Ga-based oxide, an In-Ga-Zn-based oxide, an In-Al-Zn-based oxide, an In-Sn-Zn-based oxide, an Sn-Ga-Zn-based oxide, an Al-Ga-Zn-based oxide, an Sn-Al-Zn-based oxide, an In-Hf-Zn-based oxide, an In-La-Zn-based oxide, an In-Ce-Zn-based oxide, an In-Pr-Zn-based oxide, an In-Nd-Zn-based oxide, an In-Sm-Zn-based oxide, an In-Eu-Zn-based oxide, an In-Gd-Zn-based oxide, an In-Tb-Zn-based oxide, an In-Dy-Zn-based oxide, an In-Ho-Zn-based oxide, an In-Er-Zn-based oxide, an In-Tm-Zn-based oxide, an In-Yb-Zn-based oxide, an In-Lu-Zn-based oxide, an In-Sn-Ga-Zn-based oxide, an In-Hf-Ga-Zn-based oxide, an In-Al-Ga-Zn-based oxide, an In-Sn-Al-Zn-based oxide, an In-Sn-Hf-Zn-based oxide, or an In-Hf-Al-Zn-based oxide, but are not limited thereto.

Here, the term "In-Ga-Zn-based oxide" refers to an oxide having In, Ga, and Zn as its major components, and does not indicate the ratio of In, Ga, and Zn. That is, in the case of an In-Ga-Zn-based oxide, for example, the first semiconductor patterns SP1 may include indium gallium zinc oxide (IGZO, InₓGa_{y}Zn_{z}O). IGZO (In:Ga:Zn=1:1:1) that contains In, Ga, and Zn in equal proportions may be classified as an In-Ga-Zn-based oxide. A Ga-rich IGZO may have a higher Ga content and a lower In content compared to IGZO (In:Ga:Zn=1:1:1). A Ga-rich IGZO may also be classified as an In-Ga-Zn-based oxide. Additionally, an In-rich IGZO may have a higher indium content and a lower gallium content compared to IGZO (In:Ga:Zn=1:1:1). An In-rich IGZO may also be classified as an In-Ga-Zn-based oxide.

The above description has been provided taking IGZO as an example, but the present disclosure is not limited thereto. If the first semiconductor patterns SP1 include a ternary or higher metal oxide, the above description may still be applicable. Additionally, when the first semiconductor patterns SP1 include an In-Ga-Zn-based oxide, the first semiconductor patterns SP1 may further include a doped metal element in addition to In, Ga, and Zn.

The second semiconductor patterns SP2 may be positioned on the substrate 100. The second semiconductor patterns SP2 may extend in the third direction DR3. At the same height from the substrate 100, the second semiconductor patterns SP2 may be spaced apart in the second direction DR2.

The second semiconductor patterns SP2 may be positioned on (e.g., under) the first semiconductor patterns SP1. The first semiconductor patterns SP1 may overlap the second semiconductor patterns SP2 in the first direction DR1. Storage nodes SN may overlap the second semiconductor patterns SP2 in the first direction DR1.

The second semiconductor patterns SP2 may each include a first source/drain region, a second source/drain region, and a channel region between the first and second source/drain regions. Each source/drain region may be either a source or a drain, depending on the doping characteristics of the respective transistor. The first and second source/drain regions may be positioned at opposite ends of the corresponding second semiconductor pattern SP2 in the third direction DR3. The first source/drain regions, the channel regions, and the second source/drain regions of the second semiconductor patterns SP2 may serve as the first source/drain terminals, the channel regions, and the second source/drain terminals, respectively, of the read transistors RTR in FIG. 1. The first source/drain regions and second source/drain regions of the second semiconductor patterns SP2 may include p-type impurities, such as boron (B) or aluminum (Al). The first semiconductor patterns SP1 may include impurities of a first conductivity type (e.g., n-type impurities), and the second semiconductor patterns SP2 may include impurities of a second conductivity type (e.g., p-type impurities) that is different from the first conductivity type.

The first source/drain regions of the second semiconductor patterns SP2 may be electrically connected to the respective bitlines BL. The first source/drain regions of the second semiconductor patterns SP2 may be in contact with the respective bitlines BL. The second source/drain regions of the second semiconductor patterns SP2 may be electrically connected to a ground line or a power supply line.

The second semiconductor patterns SP2 may include, for example, a semiconductor material or an oxide semiconductor material. The descriptions of the semiconductor material and the oxide semiconductor material included in the second semiconductor patterns SP2 may be substantially the same as the descriptions of the semiconductor material and the oxide semiconductor material included in the first semiconductor patterns SP1. In some implementations, the second semiconductor patterns SP2 may include epitaxial silicon. In some implementations, the crystal structure of the second semiconductor patterns SP2 may be aligned with the crystal structure of the first semiconductor patterns SP1.

A wordline WL may be positioned on the substrate 100. The wordline WL may be positioned between the first semiconductor patterns SP1 and the second semiconductor patterns SP2 adjacent to the first semiconductor patterns SP1 in the first direction DR1. The wordline WL may overlap the first semiconductor patterns SP1 and the second semiconductor patterns SP2 in the first direction DR1. The first semiconductor patterns SP1 and the second semiconductor patterns SP2 adjacent to the first semiconductor patterns SP1 in the first direction DR1 may share the wordline WL.

The wordline WL may extend in the second direction DR2. The wordline WL may overlap the first semiconductor patterns SP1 that are spaced apart in the second direction DR2 and second semiconductor patterns SP2 that are adjacent to the first semiconductor patterns SP1 in the first direction DR1 and spaced apart in the second direction DR2. The first semiconductor patterns SP1 that are spaced apart in the second direction DR2 and the second semiconductor patterns SP2 that are adjacent to the first semiconductor patterns SP1 in the first direction DR1 and spaced apart in the second direction DR2 may share the wordline WL.

A first back gate line BG1 may be positioned on the substrate 100. The first back gate line BG1 may be positioned on the first semiconductor patterns SP1. The first semiconductor patterns SP1 may be positioned between the wordline WL and the first back gate line BG1 adjacent to the wordline WL in the first direction DR1. The first back gate line BG1 may overlap the first semiconductor patterns SP1 in the first direction DR1.

The first back gate line BG1 may extend in the second direction DR2. The first back gate line BG1 may overlap the first semiconductor patterns SP1 that are spaced apart in the second direction DR2. The first semiconductor patterns SP1 that are spaced apart in the second direction DR2 may share the first back gate line BG1. The first back gate line BG1 may overlap the wordline WL in the first direction DR1.

A second back gate line BG2 may be positioned on the substrate 100. The second back gate line BG2 may be positioned on (e.g., under) the second semiconductor patterns SP2. The second semiconductor patterns SP2 may be positioned between the wordline WL and the second back gate line BG2 adjacent to the wordline WL in the first direction DR1. The second back gate line BG2 may overlap the second semiconductor patterns SP2 in the first direction DR1.

The second back gate line BG2 may extend in the second direction DR2. The second back gate line BG2 may overlap the second semiconductor patterns SP2 that are spaced apart in the second direction DR2. The second semiconductor patterns SP2 that are spaced apart in the second direction DR2 may share a second back gate line BG2. The second back gate line BG2 may overlap the wordline WL in the first direction DR1. The second back gate line BG2 may overlap the first back gate line BG1 in the first direction DR1.

The wordline WL, the first back gate line BG1, and the second back gate line BG2 may each include a conductive material. For example, the wordline WL, the first back gate line BG1, and the second back gate line BG2 may each include at least one of a doped semiconductor material, a conductive metal nitride, a conductive metal silicon nitride, a metal carbonitride, a conductive metal silicide, a conductive metal oxide, a 2D material, or a metal. The wordline WL, the first back gate line BG1, and the second back gate line BG2 are illustrated as single layers, but are not limited thereto.

The first direction DR1 may be perpendicular to the second and third directions DR2 and DR3. The second direction DR2 may intersect (e.g., may be perpendicular to) the third direction DR3.

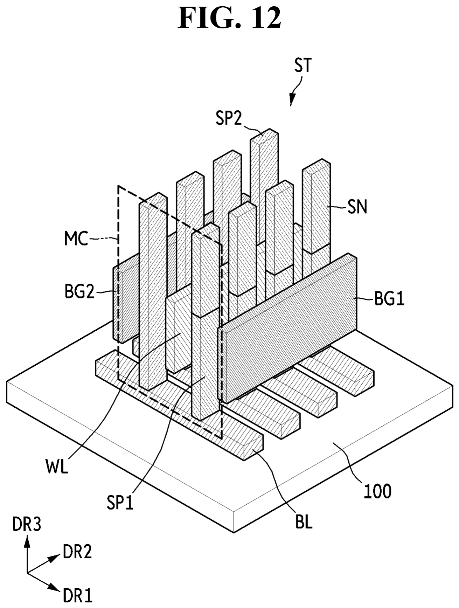

In some implementations, the first direction DR1 may be perpendicular to the upper surface of the substrate 100, and the second and third directions DR2 and DR3 may be parallel to the upper surface of the substrate 100. That is, the first semiconductor patterns SP1 and the second semiconductor patterns SP2 may extend in the third direction DR3, which is parallel to the upper surface of the substrate 100. The bitlines BL may extend in the first direction DR1, which is perpendicular to the upper surface of the substrate 100, and the wordline WL, the first back gate line BG1, and the second back gate line BG2 may extend in the second direction DR2, which is parallel to the upper surface of the substrate 100. Nevertheless, as noted later (e.g., with reference to FIG. 12), the orientation of the first direction DR1, second direction DR2 and third direction DR3 relative to the substrate 100 may be varied.

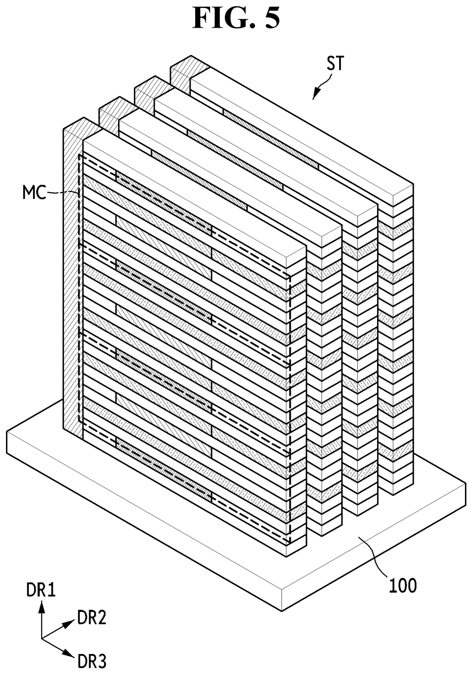

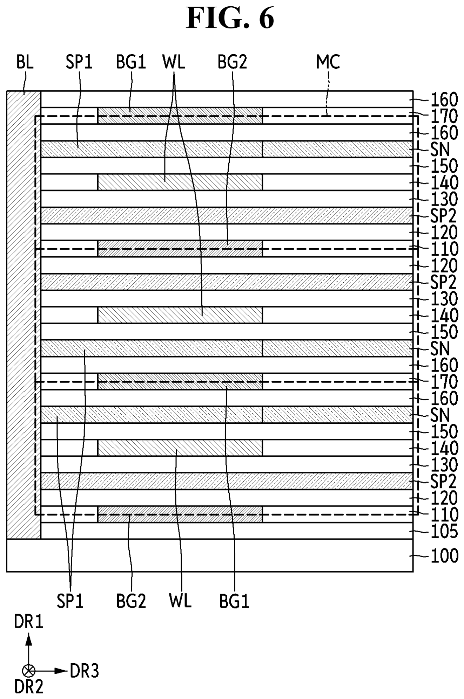

FIG. 5 is an example perspective view of a semiconductor memory device according to some implementations. FIG. 6 is an example cross-sectional view of the semiconductor memory device in FIG. 5. For convenience, the following description will focus on differences from the implementations described with reference to FIGS. 1 through 4.

Referring to FIGS. 5 and 6, in the semiconductor memory device according to some implementations, a stack structure ST may include a plurality of memory cells MC arranged in a first direction DR1 and a second direction DR2. The stack structure ST may include bitlines BL, first semiconductor patterns SP1, second semiconductor patterns SP2, wordlines WL, first back gate lines BG1, and second back gate lines BG2.

The second back gate lines BG2 and the first back gate lines BG1 may be alternately spaced apart along the first direction DR1. Each wordline WL may be positioned between first and second back gate lines BG1 and BG2 adjacent in the first direction DR1. Each second semiconductor pattern SP2 may be positioned between a wordline WL and a second back gate line BG2 adjacent in the first direction DR1. Each first semiconductor pattern SP1 and each storage node SN may be positioned between a wordline WL and a first back gate line BG1 adjacent in the first direction DR1.

Second semiconductor patterns SP2 adjacent in the first direction DR1 may overlap and share the second back gate line BG2 located therebetween in the first direction DR1. For instance, each second back gate line BG2 may be located between a corresponding pair of second semiconductor patterns SP2 that are adjacent to each other in the first direction DR1. The second semiconductor patterns SP2 adjacent in the first direction DR1 may share the second back gate line BG2 located therebetween. First semiconductor patterns SP1 adjacent in the first direction DR1 may overlap and share the first back gate line BG1 located therebetween in the first direction DR1. For instance, each first back gate line BG1 may be located between a corresponding pair of first semiconductor patterns SP1 that are adjacent to each other in the first direction DR1. The first semiconductor patterns SP1 adjacent in the first direction DR1 may share the first back gate line BG1 located therebetween.

The stack structure ST may further include protective insulating layers 105, first insulating layers 110, second insulating layers 120, third insulating layers 130, fourth insulating layers 140, fifth insulating layers 150, sixth insulating layers 160, and seventh insulating layers 170.

The protective insulating layers 105 may be positioned on the substrate 100. The second back gate lines BG2 may be positioned within the first insulating layers 110. The first insulating layers 110 may be positioned between the bitlines BL and the second back gate lines BG2. The second insulating layers 120 may be positioned in the first direction DR1 between the first insulating layers 110 and the second back gate lines BG2 adjacent to the first insulating layers 110, and the second semiconductor patterns SP2. The wordlines WL may be positioned within the fourth insulating layers 140. The fourth insulating layers 140 may be positioned between the bitlines BL and the wordlines WL. The third insulating layers 130 may be positioned in the first direction DR1 between the fourth insulating layers 140 and the wordlines WL adjacent to the fourth insulating layers 140, and the second semiconductor patterns SP2. The second semiconductor patterns SP2 may be positioned between the second insulating layers 120 and the third insulating layers 130. The fifth insulating layers 150 may be positioned in the first direction DR1 between the fourth insulating layers 140 and the wordlines WL adjacent to the fourth insulating layers 140, and the storage nodes SN. The first back gate lines BG1 may be positioned within the seventh insulating layers 170. The seventh insulating layers 170 may be positioned between the bitlines BL and the first back gate lines BG1. The sixth insulating layers 160 may be positioned in the first direction DR1 between the first semiconductor patterns SP1 and the storage nodes SN adjacent to the first semiconductor patterns SP1, and the first back gate lines BG1 and the seventh insulating layers 170.

Two adjacent memory cells MC in the first direction DR1 may be symmetrical with respect to the first back gate line BG1 or the second back gate line BG2 that they share.

For example, two adjacent memory cells MC in the first direction DR1 may share a first back gate line BG1 and a seventh insulating layer 170. In this example, below the shared first back gate line BG1 and seventh insulating layer 170, a first insulating layer 110, a second insulating layer 120 and a second back gate line BG2, a second semiconductor pattern SP2, a third insulating layer 130, a wordline WL and a fourth insulating layer 140, a fifth insulating layer 150, a first semiconductor pattern SP1 and a storage node SN, and a sixth insulating layer 160 may be sequentially stacked along the first direction DR1, and above the shared first back gate line BG1 and seventh insulating layer 170, a sixth insulating layer 160, a first semiconductor pattern SP1 and a storage node SN, a fifth insulating layer 150, a wordline WL and a fourth insulating layer 140, a third insulating layer 130, a second semiconductor pattern SP2, a second insulating layer 120, and a second back gate line BG2 and a first insulating layer 110 may be sequentially stacked along the first direction DR1. For example, two adjacent memory cells MC in the first direction DR1 may share a second back gate line BG2 and a first insulating layer 110. In this example, below the shared second back gate line BG2 and first insulating layer 110, a first back gate line BG1 and a seventh insulating layer 170, a sixth insulating layer 160, a first semiconductor pattern SP1 and a storage node SN, a fifth insulating layer 150, a wordline WL and a fourth insulating layer 140, a third insulating layer 130, a second semiconductor pattern SP2, and a second insulating layer 120 may be sequentially stacked, and above the shared second back gate line BG2 and first insulating layer 110, a second insulating layer 120, a second semiconductor pattern SP2, a third insulating layer 130, a wordline WL and a fourth insulating layer 140, a fifth insulating layer 150, a first semiconductor pattern SP1 and a storage node SN, a sixth insulating layer 160, and a first back gate line BG1 and a seventh insulating layer 170 may be sequentially stacked along the first direction DR1.

The protective insulating layers 105, the first insulating layers 110, the second insulating layers 120, the third insulating layers 130, the fourth insulating layers 140, the fifth insulating layers 150, the sixth insulating layers 160, and the seventh insulating layers 170 may each include an insulating material. For example, the protective insulating layers 105, the first insulating layers 110, the second insulating layers 120, the third insulating layers 130, the fourth insulating layers 140, the fifth insulating layers 150, the sixth insulating layers 160, and the seventh insulating layers 170 may each include silicon oxide, silicon oxynitride, a high-k insulating material having a higher dielectric constant than silicon oxide, or a combination thereof. The high-k insulating material may include a metal oxide or a metal oxynitride. For example, the high-k insulating material may include at least one of hafnium oxide, hafnium silicon oxide, hafnium silicon oxynitride, hafnium tantalum oxide, hafnium titanium oxide, hafnium zirconium oxide, zirconium oxide, aluminum oxide, or lanthanum oxide, but is not limited thereto. The high-k insulating material may be an insulating material having a dielectric constant that is greater than that of silicon oxide.

Although not illustrated, insulating layers may be positioned between bitlines BL adjacent in the second direction DR2, between protective insulating layers 105 adjacent in the second direction DR2, between first insulating layers 110 adjacent in the second direction DR2, between second insulating layers 120 adjacent in the second direction DR2, between first semiconductor patterns SP1 adjacent in the second direction DR2, between third insulating layers 130 adjacent in the second direction DR2, between fourth insulating layers 140 adjacent in the second direction DR2, between fifth insulating layers 150 adjacent in the second direction DR2, between second semiconductor patterns SP2 and storage nodes SN adjacent to the second semiconductor patterns SP2 in the second direction DR2, between sixth insulating layers 160 adjacent in the second direction DR2, and between seventh insulating layers 170 adjacent in the second direction DR2. Additionally, the second semiconductor patterns SP2 may protrude beyond the storage nodes SN in the third direction DR3.

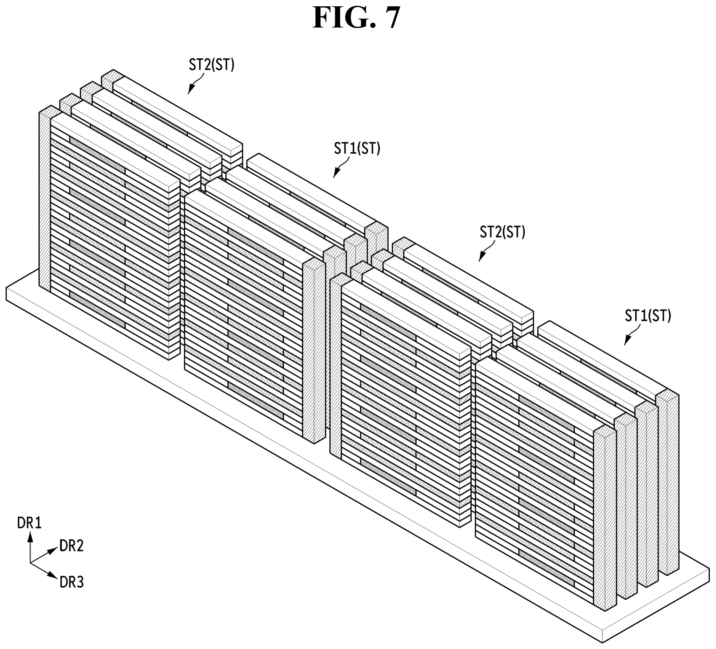

FIG. 7 is an example perspective view of a semiconductor memory device according to some implementations. For convenience, the following description will focus on differences from the implementation described with reference to FIGS. 5 and 6.

Referring to FIG. 7, in the semiconductor memory device according to some implementations, stack structures ST may be spaced apart in a third direction DR3.

For example, the stack structures ST may include first stack structures ST1 and second stack structures ST2, which are adjacent to the first stack structures ST1 in the third direction DR3. The first stack structures ST1 and the second stack structures ST2 may be alternately arranged in the third direction DR3. A pair of first and second stack structures ST1 and ST2 adjacent in the third direction DR3 may be symmetrical with respect to an imaginary extension line extending in the first direction DR1 therebetween. For instance, a pair of first and second stack structures ST1 and ST2 adjacent in the third direction DR3 may be symmetrical with respect to a plane of symmetry extending in the first direction DR1 and the second direction DR2 therebetween. For example, in the pair of first and second stack structures ST1 and ST2 adjacent in the third direction DR3, bitlines BL in the first stack structure ST1 and bitlines BL in the second stack structure ST2 may be arranged in opposite directions (e.g., on opposite sides of the respective stack structures), and the first and second stack structures ST1 and ST2 may be symmetrical with respect to an imaginary extension line (e.g., an axis) extending in the first direction DR1 (e.g., in a plane of symmetry extending in the first direction DR1 and second direction DR2) between the bitlines BL of the first stack structure ST1 and the bitlines BL of the second stack structure ST2.

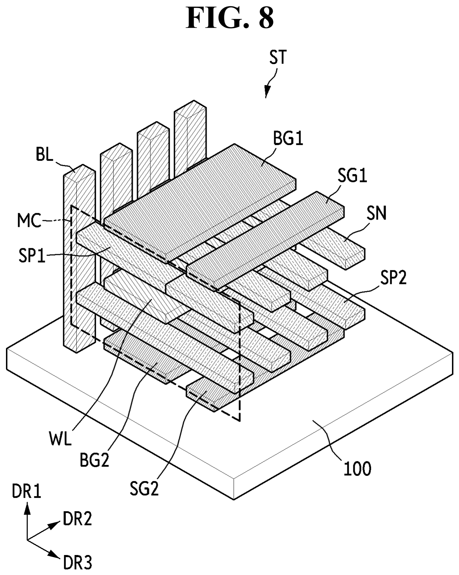

FIG. 8 is an example perspective view of a semiconductor memory device according to some implementations. For convenience, the following description will focus on differences from the implementations described with reference to FIGS. 1 through 4.

Referring to FIG. 8, in the semiconductor memory device according to some implementations, a stack structure ST may further include a first shield gate line SG1 and a second shield gate line SG2.

The first shield gate line SG1 may be positioned on storage nodes SN. The first shield gate line SG1 may be spaced apart from a first back gate line BG1 in a third direction DR3. The first shield gate line SG1 may overlap the storage nodes SN in a first direction DR1.

The first shield gate line SG1 may extend in a second direction DR2. The first shield gate line SG1 may overlap storage nodes SN that are spaced apart in the second direction DR2 and adjacent in the first direction DR1. The storage nodes SN that are spaced apart in the second direction DR2 may share the first shield gate line SG1. The first shield gate line SG1 may maintain or enhance the electric field effect on the storage nodes SN. Accordingly, the retention time of the semiconductor memory device according to some implementations may increase. The voltage applied to the first shield gate line SG1 may be adjusted according to the characteristics of memory cells MC.

The second shield gate line SG2 may be positioned on (e.g., under) second semiconductor patterns SP2. The second shield gate line SG2 may be spaced apart from a second back gate line BG2 in the third direction DR3. The second shield gate line SG2 may overlap the second semiconductor patterns SP2 in the first direction DR1.

The second shield gate line SG2 may extend in the second direction DR2. The second shield gate line SG2 may overlap second semiconductor patterns SP2 that are spaced apart in the second direction DR2. The second semiconductor patterns SP2 that are spaced apart in the second direction DR2 may share the second shield gate line SG2. The second shield gate line SG2 may increase the current flowing through read transistors RTR. Accordingly, the read operation margin of the semiconductor memory device according to some implementations may increase. The voltage applied to the second shield gate line SG2 may be adjusted according to the characteristics of the memory cells MC.

The first and second shield gate lines SG1 and SG2 may each include a conductive material. For example, the first and second shield gate lines SG 1 and SG2 may each include at least one of a doped semiconductor material, a conductive metal nitride, a conductive metal silicon nitride, a metal carbonitride, a conductive metal silicide, a conductive metal oxide, a 2D material, or a metal. The first and second shield gate lines SG1 and SG2 are illustrated as single layers, but are not limited thereto.

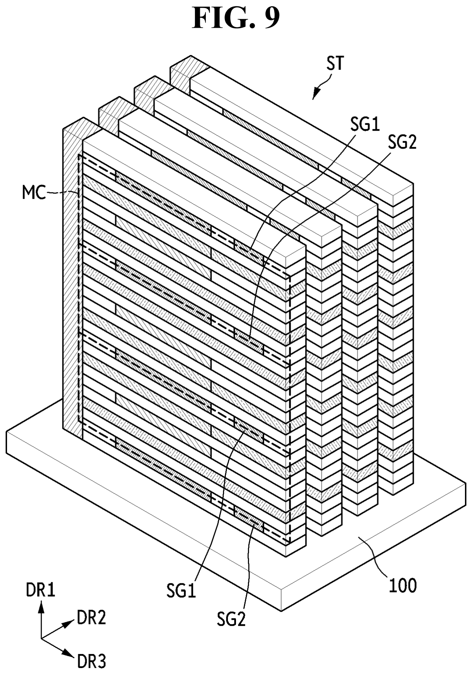

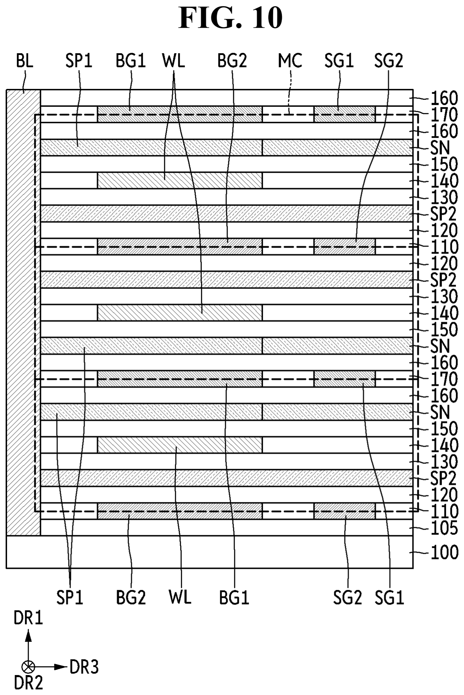

FIG. 9 is an example perspective view of a semiconductor memory device according to some implementations. FIG. 10 is an example cross-sectional view of the semiconductor memory device in FIG. 9. For convenience, the following description will focus on differences from the implementation described with reference to FIG. 8.

Referring to FIGS. 9 and 10, in the semiconductor memory device according to some implementations, a stack structure ST may include a plurality of memory cells MC arranged in a first direction DR1 and a second direction DR2. The stack structure ST may include bitlines BL, first semiconductor patterns SP1, second semiconductor patterns SP2, wordlines WL, first back gate lines BG1, first shield gate lines SG1, second back gate lines BG2, and second shield gate lines SG2.

Each of the first shield gate lines SG1 may be positioned between two adjacent storage nodes SN in the first direction DR1. Each of the second shield gate lines SG2 may be positioned between two adjacent second semiconductor patterns SP2 in the first direction DR1.

Adjacent storage nodes SN in the first direction DR1 may overlap and share the first shield gate line SG1 located therebetween in the first direction DR1. The first shield gate lines SG1 may be positioned within seventh insulating layers 170. The seventh insulating layers 170 may be positioned between the first back gate lines BG1 and the first shield gate lines SG1. Sixth insulating layers 160 may be positioned between the first shield gate lines SG1 and the storage nodes SN adjacent to the first shield gate lines SG1 in the first direction DR1.

Adjacent second semiconductor patterns SP2 in the first direction DR1 may overlap and share the second shield gate line SG2 located therebetween in the first direction DR1. The second shield gate lines SG2 may be positioned within first insulating layers 110. The first insulating layers 110 may be positioned between the second back gate lines BG2 and the second shield gate lines SG2. Second insulating layers 120 may be positioned between the second shield gate lines SG2 and the second semiconductor patterns SP2 adjacent to the second shield gate lines SG2 in the first direction DR1.

Two memory cells MC connected to the same bitline BL and adjacent in the first direction DR1 may share either a first back gate line BG1 and a first shield gate line SG1, or a second back gate line BG2 and a second shield gate line SG2. Two memory cells MC adjacent in the first direction DR1 may be symmetrical with respect to their shared first back gate line BG1 and first shield gate line SG1, or their shared second back gate line BG2 and second shield gate line SG2.

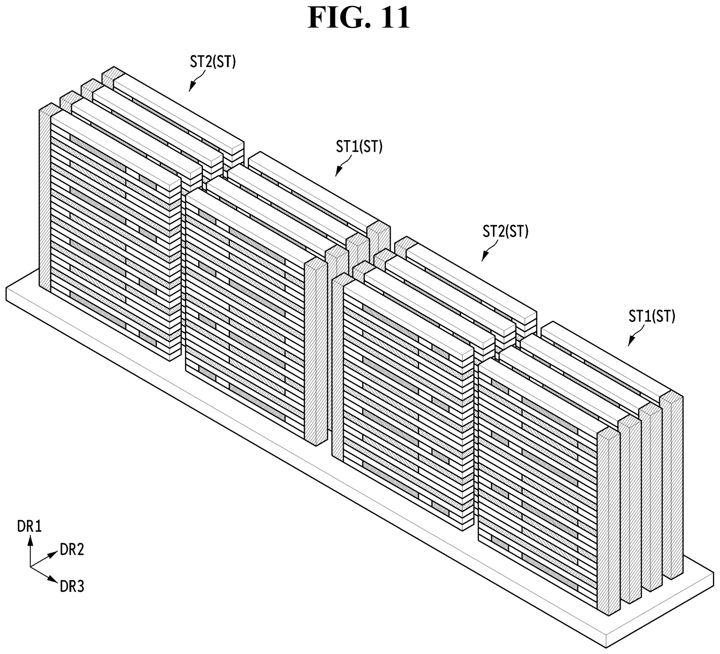

FIG. 11 is an example perspective view of a semiconductor memory device according to some implementations. For convenience, the following description will focus on differences from the implementation described with reference to FIGS. 9 and 10.

Referring to FIG. 11, in the semiconductor memory device according to some implementations, stack structures ST may be spaced apart in a third direction DR3.

For example, the stack structures ST may include first stack structures ST1 and second stack structures ST2, which are adjacent to the first stack structures ST1 in the third direction DR3. The first stack structures ST1 and the second stack structures ST2 may be sequentially arranged in the third direction DR3. A pair of first and second stack structures ST1 and ST2 adjacent in the third direction DR3 may be symmetrical with respect to an imaginary extension line extending in the first direction DR1 therebetween. For example, a pair of first and second stack structures ST1 and ST2 adjacent in the third direction DR3 may be symmetrical with respect to a plane of symmetry extending in the first direction DR1 and the second direction DR2 therebetween. For example, in the pair of first and second stack structures ST1 and ST2 adjacent in the third direction DR3, bitlines BL in the first stack structure ST1 and bitlines BL in the second stack structure ST2 may be arranged in opposite directions (e.g., on opposite sides of the respective stack structures), and the first and second stack structures ST1 and ST2 may be symmetrical with respect to an imaginary extension line extending in the first direction DR1 (e.g., in a plane of symmetry extending in the first direction DR1 and second direction DR2) between the bitlines BL of the first stack structure ST1 and the bitlines BL of the second stack structure ST2.

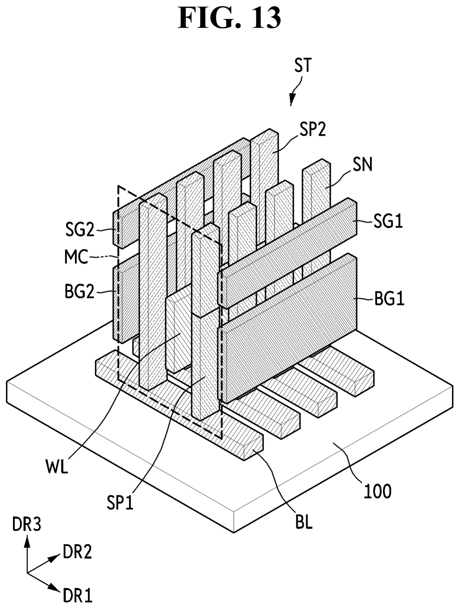

FIGS. 12 and 13 are example perspective views of semiconductor memory devices according to some implementations. For convenience, the following description will focus on differences from the implementations described with reference to FIGS. 1 through 4.

Referring to FIGS. 12 and 13, in the semiconductor memory devices according to some implementations, a first direction DR1 and a second direction DR2 may be parallel to the upper surface of a substrate 100, and a third direction DR3 may be perpendicular to the upper surface of the substrate 100. That is, first semiconductor patterns SP1 and second semiconductor patterns SP2 may extend in the third direction DR3, which is perpendicular to the upper surface of the substrate 100. Bitlines BL may extend in the first direction DR1, which is parallel to the upper surface of the substrate 100, and wordlines WL, first back gate lines BG1, and second back gate lines BG2 may extend in the second direction DR2, which is parallel to the upper surface of the substrate 100.

Unlike what is illustrated, a stack structure ST may include a plurality of memory cells MC arranged in the first and second directions DR1 and DR2. Two memory cells MC connected to the same bitline BL and adjacent in the first direction DR1 may share either a first back gate line BG1 or a second back gate line BG2. Second semiconductor patterns SP2 adjacent in the first direction DR1 may share the second back gate line BG2 located therebetween. First semiconductor patterns SP1 adjacent in the first direction DR1 may share the first back gate line BG1 located therebetween. Memory cells MC adjacent in the first direction DR1 may be symmetrical with respect to the first back gate line BG1 or the second back gate line BG2 that they share.

Referring to FIG. 13, in the semiconductor memory device according to some implementations, each of the memory cells MC may further include a first shield gate line SG1 and a second shield gate line SG2. The first and second shield gate lines SG1 and SG2 may extend in the second direction DR2, which is parallel to the upper surface of the substrate 100.

Unlike what is illustrated, in some implementations, the stack structure ST may include a plurality of memory cells MC arranged in the first and second directions DR1 and DR2. Two memory cells MC connected to the same bitline BL and adjacent in the first direction DR1 may share either a first back gate line BG1 and a first shield gate line SG1, or a second back gate line BG2 and a second shield gate line SG2. Second semiconductor patterns SP2 adjacent in the first direction DR1 may share the second back gate line BG2 and the second shield gate line SG2 located therebetween. First semiconductor patterns SP1 adjacent in the first direction DR1 may share the first back gate line BG1 and the first shield gate line SG1 located therebetween. Two memory cells MC adjacent in the first direction DR1 may be symmetrical with respect to the first back gate line BG1 or the second back gate line BG2 that they share. Specifically, two memory cells MC adjacent in the first direction DR1 may be symmetrical with respect to their shared first back gate line BG1 and first shield gate line SG1 or their shared second back gate line BG2 and second shield gate line SG2.

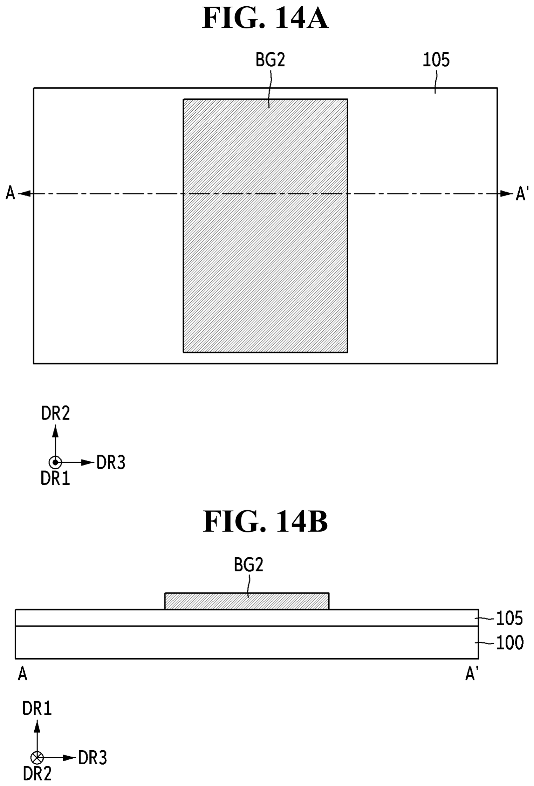

FIGS. 14A through 27A are plan views for explaining a method for manufacturing a semiconductor memory device according to some implementations. FIGS. 14B through 27B are cross-sectional views taken along lines A-A' of FIGS. 14A through 27A, respectively. For convenience, the following description will focus on differences from the implementations described with reference to FIGS. 1 through 6.

Referring to FIGS. 14A and 14B, a protective insulating layer 105 may be formed on a substrate 100. The protective insulating layer 105 may cover the upper surface of the substrate 100.

Thereafter, a second back gate line BG2 may be formed on the protective insulating layer 105. The second back gate line BG2 may extend in a second direction DR2.

For example, a mask pattern including an opening that exposes a portion of the upper surface of the protective insulating layer 105 may be formed on the protective insulating layer 105, a preliminary gate line may be formed on the mask pattern and the opening, and the preliminary gate line on the mask pattern and the mask pattern may be removed, thereby forming a second back gate line BG2. In another example, a preliminary gate line may be formed on the protective insulating layer 105, and may then be patterned, thereby forming the second back gate line BG2.

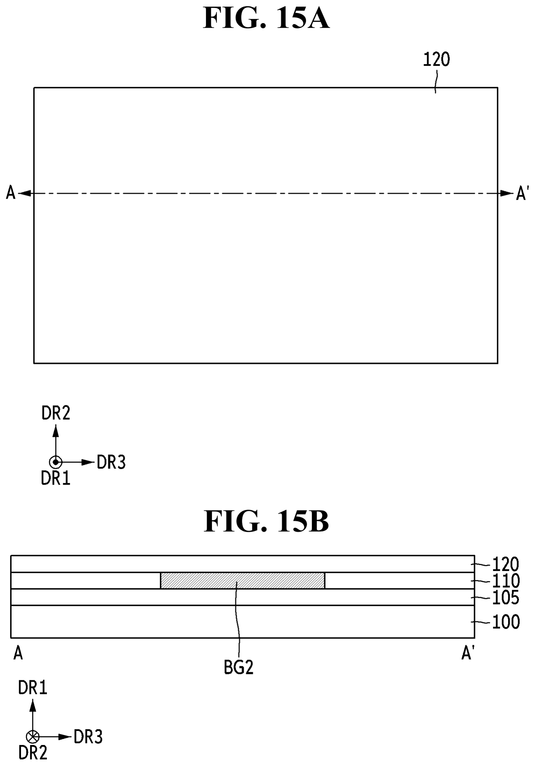

Referring to FIGS. 15A and 15B, a first insulating layer 110 may be formed on the protective insulating layer 105. The first insulating layer 110 may surround the second back gate line BG2. The upper surface of the second back gate line BG2 may be exposed through the first insulating layer 110.

Thereafter, a second insulating layer 120 may be formed on the first insulating layer 110 and the second back gate line BG2.

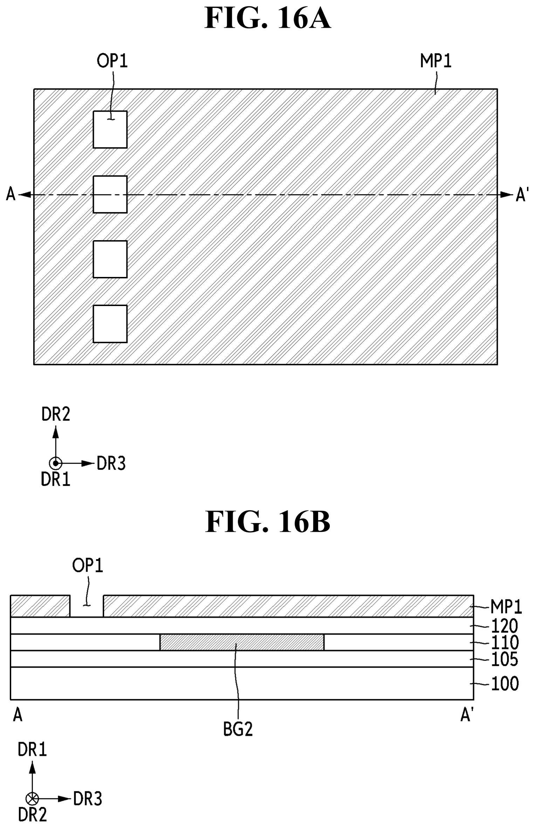

Referring to FIGS. 16A and 16B, a first mask pattern MP1 including first openings OP1 may be formed on the second insulating layer 120. The first openings OP1 may expose portions of the upper surface of the second insulating layer 120. The first openings OP1 may be spaced apart in the second direction DR2.

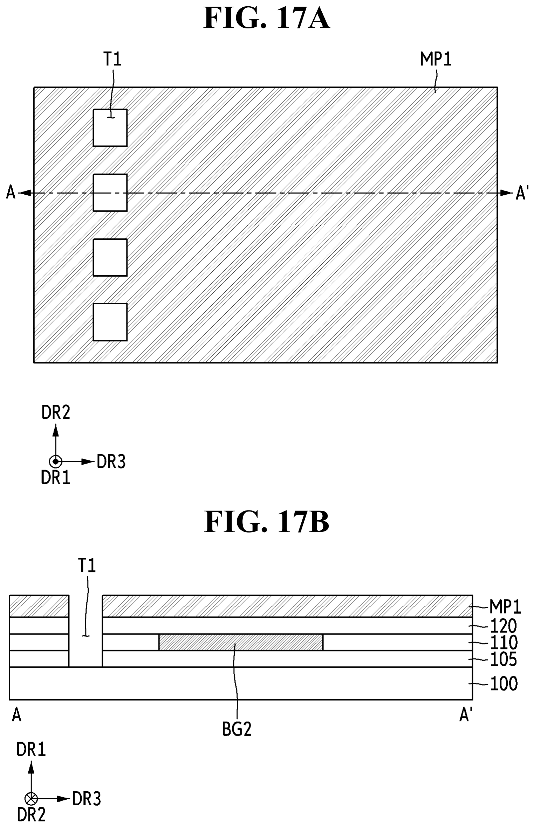

Referring to FIGS. 17A and 17B, first trenches T1 may be formed using the first mask pattern MP1 as an etch mask. The first trenches T1 may be formed by etching the protective insulating layer 105 and the first and second insulating layers 110 and 120 through the first openings OP1 of the first mask pattern MP1 (in FIGS. 16A and 16B). The first trenches T1 may expose at least portions of the substrate 100. The first trenches T1 may be spaced apart from the second back gate line BG2 in the third direction DR3. The first trenches T1 may also be spaced apart in the second direction DR2.

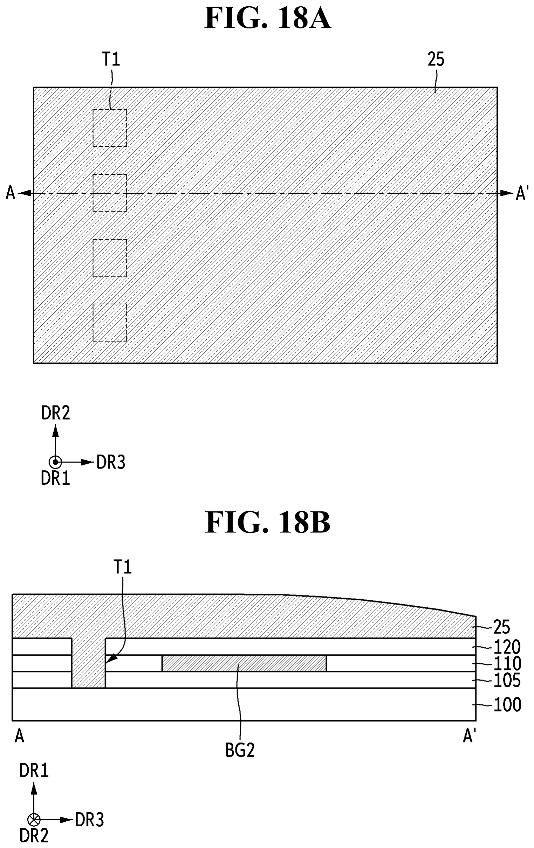

Referring to FIGS. 18A and 18B, the first mask pattern MP1 (in FIGS. 17A and 17B) may be removed.

Thereafter, a second semiconductor film 25 may be formed. The second semiconductor film 25 may be formed by an epitaxial growth process using the substrate 100 as a seed layer. The second semiconductor film 25 may be an epitaxial silicon film. Accordingly, there may be no boundary between the substrate 100 and the second semiconductor film 25. Due to the epitaxial growth process, the crystal structure of the second semiconductor film 25 may be aligned with that of the substrate 100. The second semiconductor film 25 may fill the first trenches T1. The second semiconductor film 25 may cover the second insulating layer 120.

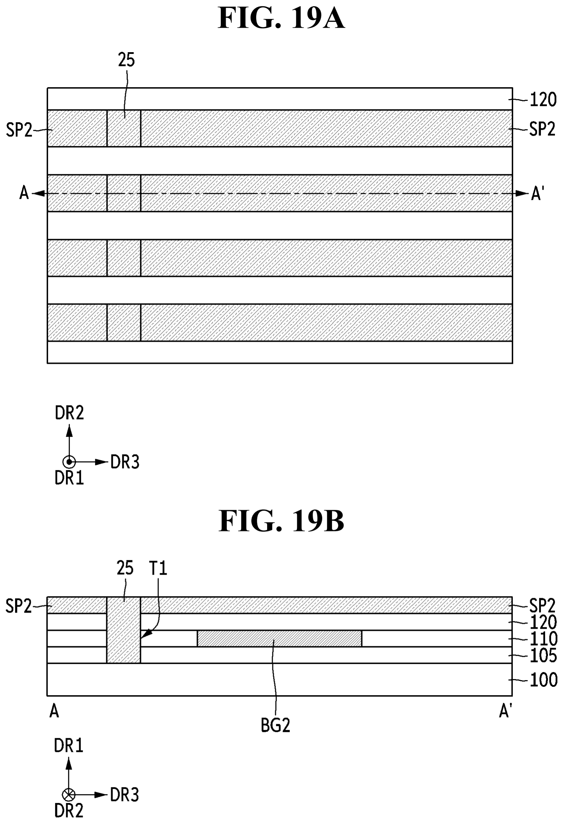

Referring to FIGS. 19A and 19B, a planarization process may be performed on the second semiconductor film 25. For example, a chemical mechanical polishing (CMP) process may be performed on the second semiconductor film 25.

Thereafter, the second semiconductor film 25 on the second insulating layer 120 may be patterned, thereby forming second semiconductor patterns SP2. The second semiconductor patterns SP2 may extend in a third direction DR3 and may be spaced apart in the second direction DR2. A doping process may also be performed, thereby forming second semiconductor patterns SP2 that each include a channel region and first and second source/drain regions.

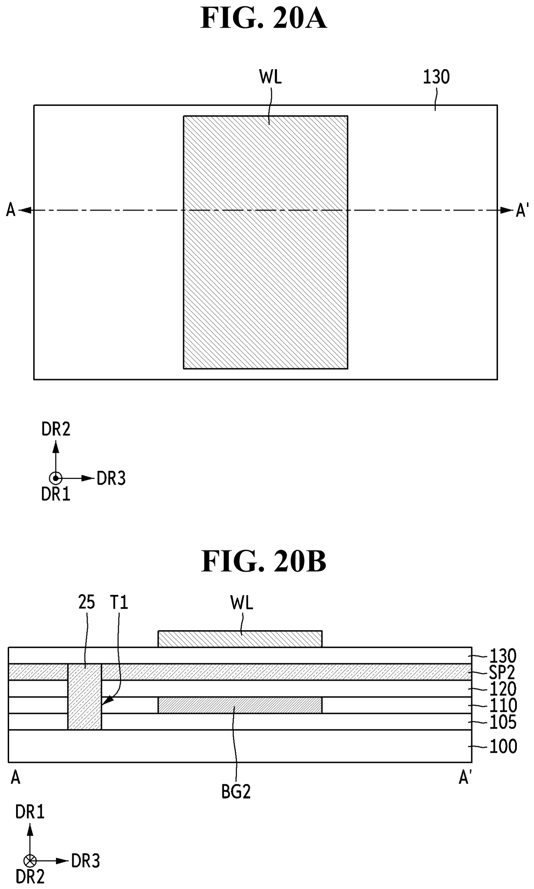

Referring to FIGS. 20A and 20B, a third insulating layer 130 may be formed on the second semiconductor patterns SP2. The third insulating layer 130 may fill spaces between the second semiconductor patterns SP2. The third insulating layer 130 may cover the second semiconductor patterns SP2 and the second insulating layer 120.

Thereafter, a wordline WL may be formed on the third insulating layer 130. The wordline WL may extend in the second direction DR2. The wordline WL may overlap the second semiconductor patterns SP2 in the first direction DR1.

For example, a mask pattern including an opening that exposes a portion of the upper surface of the third insulating layer 130 may be formed on the third insulating layer 130, a preliminary gate line may be formed on the mask pattern and the opening, and the preliminary gate line on the mask pattern and the mask pattern may be removed, thereby forming the wordline WL. In another example, a preliminary gate line may be formed on the third insulating layer 130 and then patterned, thereby forming the wordline WL.

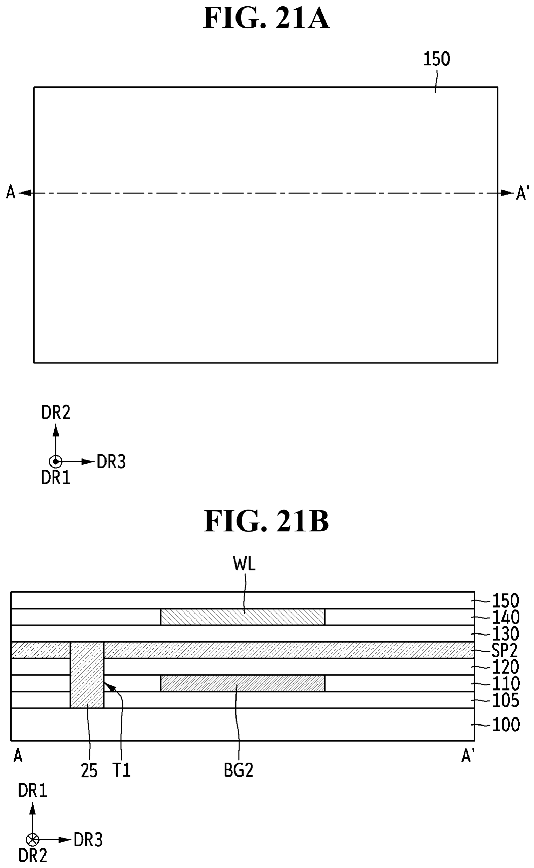

Referring to FIGS. 21A and 21B, a fourth insulating layer 140 may be formed on the third insulating layer 130. The fourth insulating layer 140 may surround the wordline WL. The upper surface of the wordline WL may be exposed through the fourth insulating layer 140.

Thereafter, a fifth insulating layer 150 may be formed on the fourth insulating layer 140 and the wordline WL.

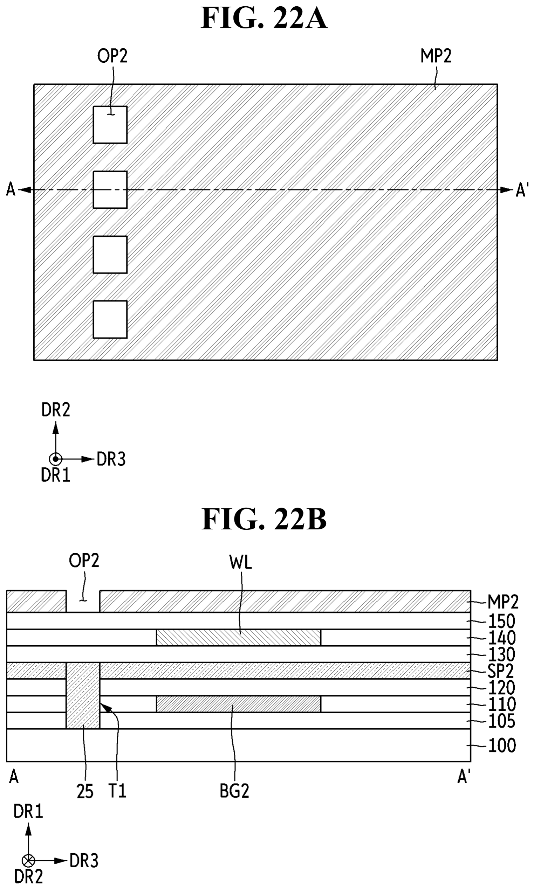

Referring to FIGS. 22A and 22B, a second mask pattern MP2 including second openings OP2 may be formed on the fifth insulating layer 150. The second openings OP2 may expose portions of the upper surface of the fifth insulating layer 150. The second openings OP2 may overlap the second semiconductor film 25 in the first direction DR1. The second openings OP2 may be spaced apart in the second direction DR2.

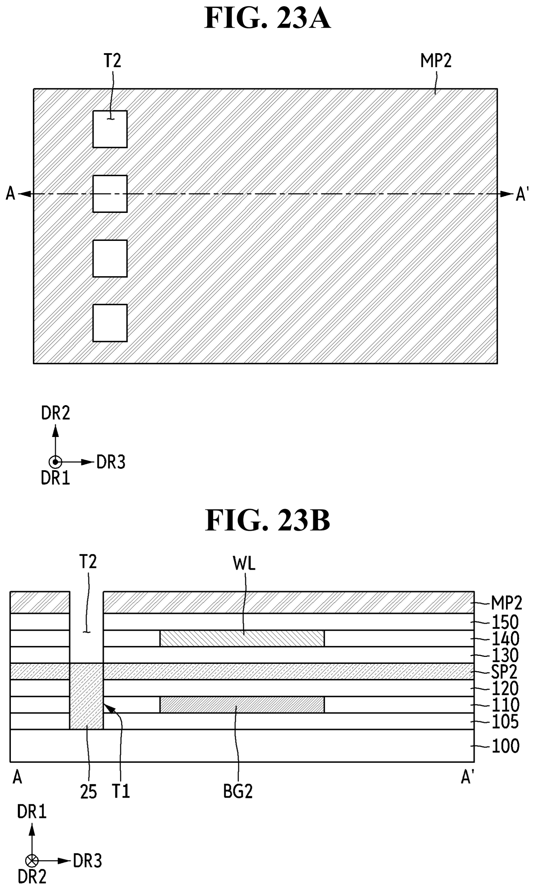

Referring to FIGS. 23A and 23B, second trenches T2 may be formed using the second mask pattern MP2 as an etch mask. The second trenches T2 may be formed by etching the third, fourth, and fifth insulating layers 130, 140, and 150 through the second openings OP2 of the second mask pattern MP2 (in FIGS. 22A and 22B). The second trenches T2 may expose at least portions of the second semiconductor film 25. The second trenches T2 may be spaced apart from the wordline WL in the third direction DR3. The second trenches T2 may also be spaced apart in the second direction DR2.

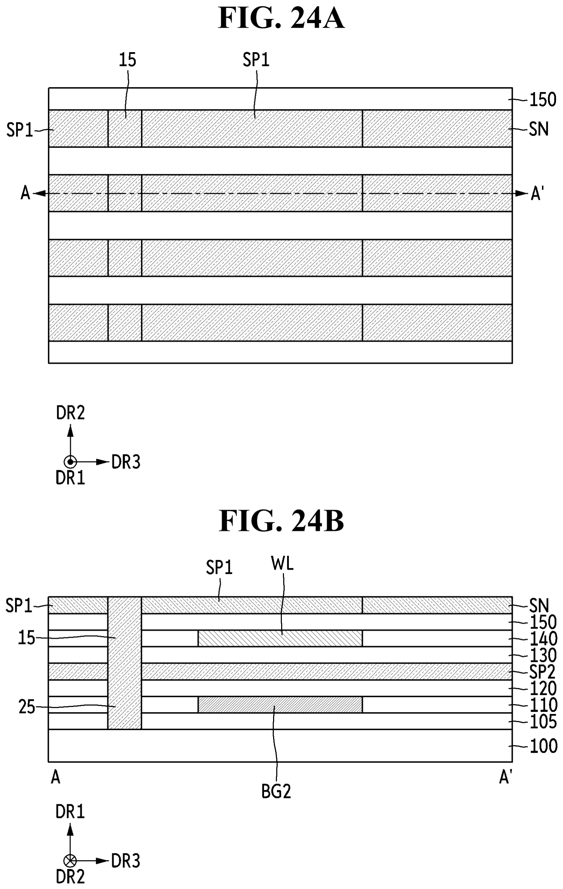

Referring to FIGS. 24A and 24B, the second mask pattern MP2 (in FIGS. 23A and 23B) may be removed.

Thereafter, first semiconductor films 15 may be formed. The first semiconductor films 15 may be formed by an epitaxial growth process using the second semiconductor film 25 as a seed layer. The first semiconductor films 15 may be an epitaxial silicon film. Accordingly, there may be no boundary between the first semiconductor films 15 and the second semiconductor film 25. Due to the epitaxial growth process, the crystal structure of the first semiconductor film 15 may be aligned with that of the second semiconductor film 25. The first semiconductor films 15 may fill the second trenches T2. The first semiconductor films 15 may cover the fifth insulating layer 150.

Thereafter, a planarization process may be performed on the first semiconductor films 15. For example, a CMP process may be performed on the first semiconductor films 15.

Thereafter, the first semiconductor films 15 on the fifth insulating layer 150 may be patterned, thereby forming first semiconductor patterns SP1. The first semiconductor patterns SP1 may extend in the third direction DR3 and may be spaced apart in the second direction DR2. A doping process may also be performed, thereby forming first semiconductor patterns SP1 that each include a channel region and first and second source/drain regions. The first semiconductor patterns SP1 may overlap the wordline WL in the first direction DR1. Storage nodes SN may be formed at the ends of the respective first semiconductor patterns SP1 in the third direction DR3. The storage nodes SN may be in contact with the ends of the respective first semiconductor patterns SP1. The storage nodes SN may be spaced apart in the second direction DR2.

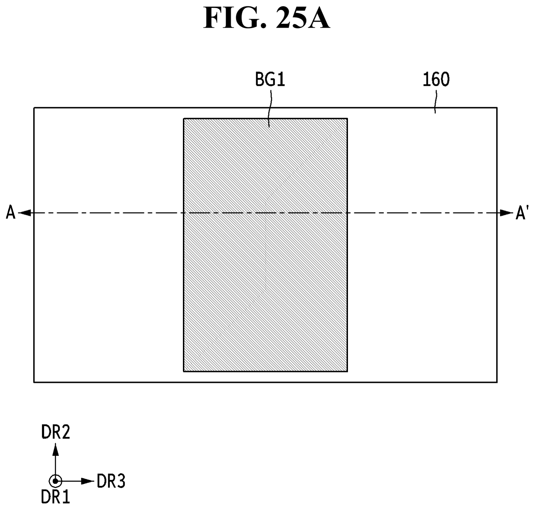

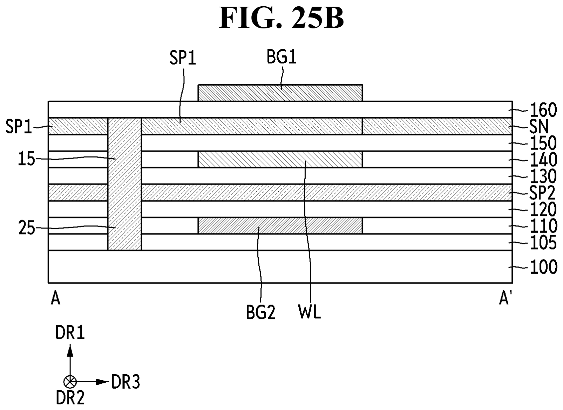

Referring to FIGS. 25A and 25B, a sixth insulating layer 160 may be formed on the first semiconductor patterns SP1 and the storage nodes SN. The sixth insulating layer 160 may fill spaces between the first semiconductor patterns SP1 and between the storage nodes SN. The sixth insulating layer 160 may cover the first semiconductor patterns SP1 and the storage nodes SN.

Thereafter, a first back gate line BG1 may be formed on the sixth insulating layer 160. The first back gate line BG1 may extend in a second direction DR2. The first back gate line BG1 may overlap the first semiconductor patterns SP1 in the first direction DR1.

For example, a mask pattern including an opening that exposes a portion of the upper surface of the sixth insulating layer 160 may be formed on the sixth insulating layer 160. A preliminary gate line may be formed on the mask pattern and the opening, and the preliminary gate line on the mask pattern and the mask pattern may be removed, thereby forming the first back gate line BG1. In another example, a preliminary gate line may be formed on the sixth insulating layer 160 and then patterned, thereby forming the first back gate line BG1.

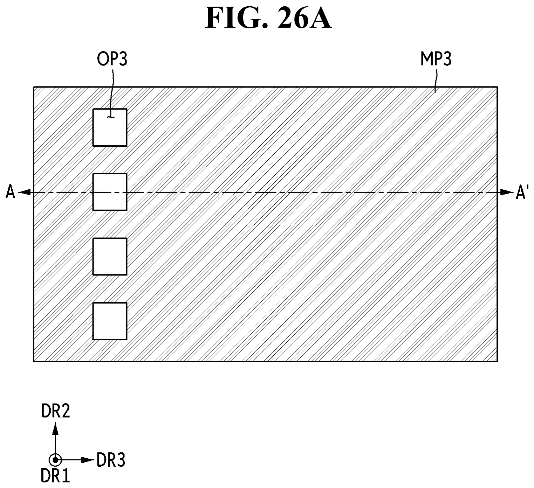

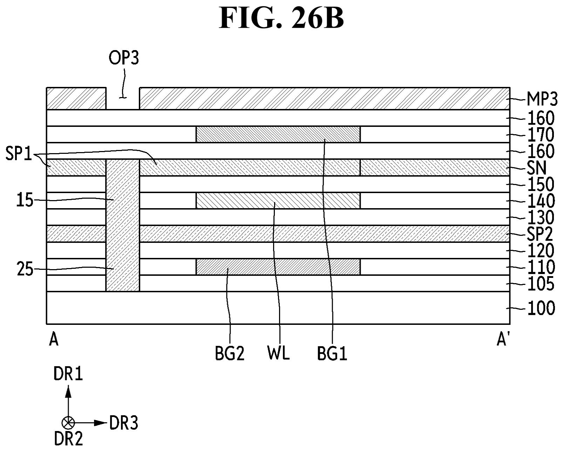

Referring to FIGS. 26A and 26B, a seventh insulating layer 170 may be formed on the sixth insulating layer 160. The seventh insulating layer 170 may surround the first back gate line BG1. The upper surface of the first back gate line BG1 may be exposed through the seventh insulating layer 170.

Thereafter, another sixth insulating layer 160 may be formed on the seventh insulating layer 170 and the first back gate line BG1.

Thereafter, a third mask pattern MP3 including third openings OP3 may be formed on the uppermost sixth insulating layer 160 relative to the upper surface of the substrate 100. The third openings OP3 may expose portions of the upper surface of the uppermost sixth insulating layer 160 relative to the upper surface of the substrate 100. The third openings OP3 may overlap the first semiconductor films 15 in the first direction DR1. The third openings OP3 may be spaced apart in the second direction DR2.

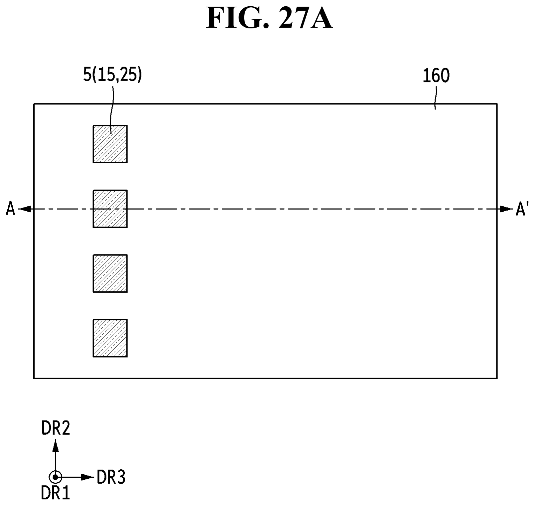

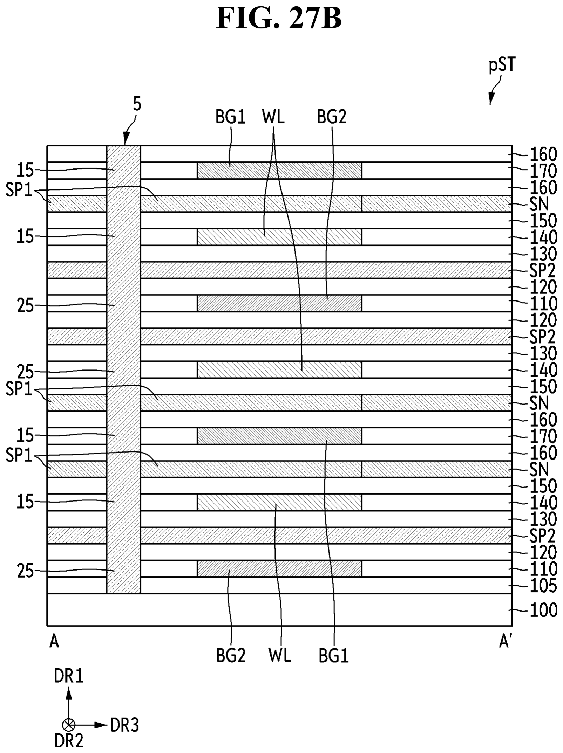

Referring to FIGS. 26A, 26B, 27A, and 27B, third trenches may be formed by etching the sixth insulating layer 160, the seventh insulating layer 170, and the sixth insulating layer 160 that are stacked sequentially on the first semiconductor patterns SP1 and the storage nodes SN, through the third openings OP3 of the third mask pattern MP3. The third trenches may expose at least portions of the first semiconductor films 15. The third trenches may be spaced apart from the first back gate line BG1 in the third direction DR3. The third trenches may also be spaced apart in the second direction DR2. The third mask pattern MP3 may be removed, and using the first semiconductor films 15 as a seed layer, first semiconductor films 15 that fill the third trenches and cover the uppermost sixth insulating layer 160 relative to the upper surface of the substrate 100 may be formed via an epitaxial growth process. Thereafter, these formed first semiconductor films 15 may be patterned, thereby forming first semiconductor patterns SP1. Storage nodes SN may be formed at the ends of the respective first semiconductor patterns SP1 in the third direction DR3.

Thereafter, using the manufacturing processes illustrated in FIGS. 14A through 26B, first insulating layers 110, second insulating layers 120, third insulating layers 130, fourth insulating layers 140, fifth insulating layers 150, sixth insulating layers 160, seventh insulating layers 170, first back gate lines BG1, wordlines WL, second back gate lines BG2, first semiconductor films 15, second semiconductor films 25, first semiconductor patterns SP1, and second semiconductor patterns SP2 may be further formed, thereby forming a preliminary stack structure pST.

The preliminary stack structure pST may be symmetrical in the first direction DR1 with respect to the second back gate lines BG2 and the first insulating layers 110, and with respect to the first back gate lines BG1 and the seventh insulating layers 170. A first insulating layer 110 and a second back gate line BG2, a second insulating layer 120, second semiconductor patterns SP2, a third insulating layer 130, a fourth insulating layer 140 and a wordline WL, a fifth insulating layer 150, first semiconductor patterns SP1 and storage nodes SN, and a sixth insulating layer 160 that are positioned below a first back gate line BG1 and a seventh insulating layer 170 in the first direction DR1 may be symmetrically arranged with a sixth insulating layer 160, first semiconductor patterns SP1 and storage nodes SN, a fifth insulating layer 150, a fourth insulating layer 140 and a wordline WL, a third insulating layer 130, second semiconductor patterns SP2, a second insulating layer 120, and a first insulating layer 110 and a second back gate line BG2 positioned above the first back gate line BG1 and the seventh insulating layer 170 in the first direction DR1. The fifth insulating layers 150 may each fill spaces between the first semiconductor patterns SP1 and the storage nodes SN positioned therebelow in the first direction DR1. The sixth insulating layers 160 may each fill spaces between the first semiconductor patterns SP1 and the storage nodes SN positioned therebelow in the first direction DR1. The second insulating layers 120 may each fill spaces between the second semiconductor patterns SP2 positioned therebelow in the first direction DR1. The third insulating layers 130 may each fill spaces between the second semiconductor patterns SP2 positioned therebelow in the first direction DR1.

The first semiconductor films 15 and the second semiconductor films 25 may be stacked in the first direction DR1. Accordingly, sacrificial films 5, each including the first semiconductor films 15 and the second semiconductor films 25 that are stacked in the first direction DR1, may be formed. The sacrificial films 5 may be spaced apart in the second direction DR2 and may extend in the first direction DR1.

Thereafter, referring to FIGS. 27A, 27B, 5, and 6, the sacrificial films 5 may be removed and bitlines BL may be formed in the spaces where the sacrificial films 5 have been removed. The bitlines BL may extend in the first direction DR1 and may be spaced apart in the second direction DR2. The first insulating layers 110, the second insulating layers 120, the third insulating layers 130, the fourth insulating layers 140, the fifth insulating layers 150, the sixth insulating layers 160, and the seventh insulating layers 170 may be positioned between bitlines BL adjacent in the second direction DR2. Memory cells MC may be formed on first sides of the bitlines BL in the third direction DR3. In addition, insulating layers may be formed to extend through second sides of the bitlines BL in the third direction DR3, where no memory cells MC are formed. Here, the second sides may be opposite to the first sides in the third direction DR3. That is, the first semiconductor patterns SP1 and second semiconductor patterns SP2 on the second sides of the bitlines BL in the third direction DR3 may be removed. Accordingly, stack structures ST, each including a plurality of memory cells MC, may be formed. FIGS. 5 and 6 may be diagrams in which the second sides of the bitlines BL in the third direction DR3 illustrated in FIGS. 27A and 27B are omitted.

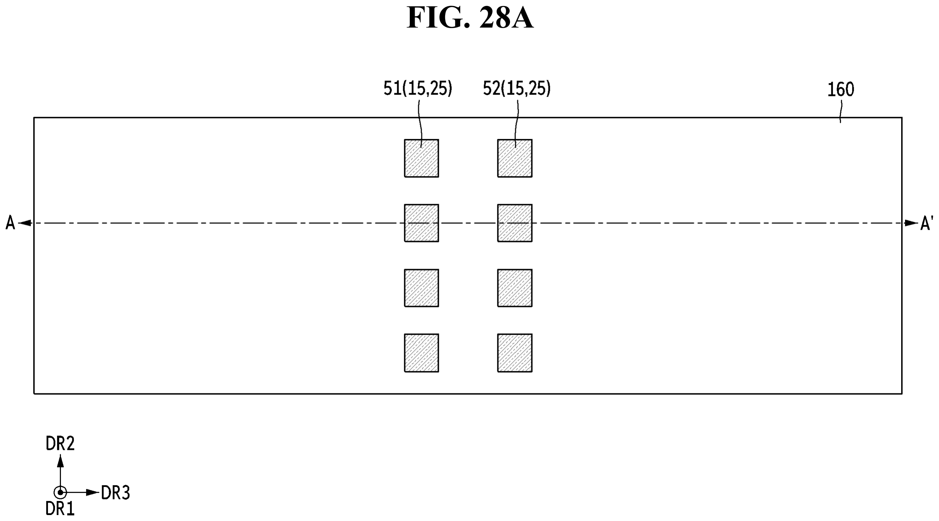

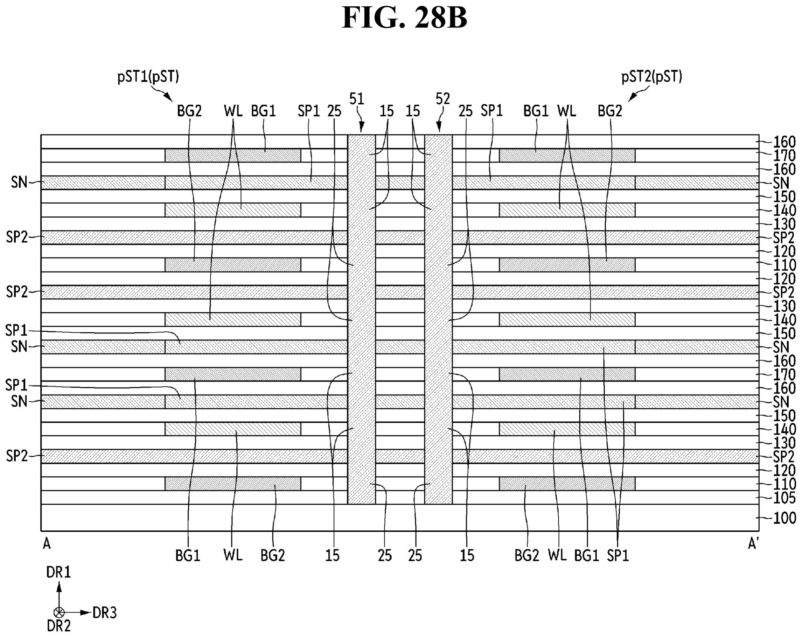

FIG. 28A is a plan view for explaining a method for manufacturing a semiconductor memory device according to some implementations. FIG. 28B is a cross-sectional view taken along line A-A' of FIG. 28A. For convenience, the following description will focus on differences from the implementation described with reference to FIGS. 14A through 27B.

Referring to FIGS. 28A and 28B, a plurality of preliminary stack structures pST may be formed simultaneously.

For example, first and second preliminary stack structures pST1 and pST2, which are adjacent in a third direction DR3, may be formed simultaneously. Protective insulating layers 105, first back gate lines BG1 and second back gate lines BG2, wordlines WL, first insulating layers 110, second insulating layers 120, third insulating layers 130, fourth insulating layers 140, fifth insulating layers 150, sixth insulating layers 160, and seventh insulating layers 170, first semiconductor films 15 and second semiconductor films 25, first semiconductor patterns SP1 and storage nodes SN, and second semiconductor patterns SP2 of the first preliminary stack structure pST1 may each be formed simultaneously with the respective counterparts of the second preliminary stack structure pST2. For example, in FIGS. 14A and 14B, the second back gate lines BG2 that are spaced apart in the third direction DR3 may be formed on the protective insulating layers 105 to form each of the first and second preliminary stack structures pST1 and pST2.

The first preliminary stack structure pST1 may include first sacrificial films 51, each including first semiconductor films 15 and second semiconductor films 25 that are stacked in a first direction DR1. Similarly, the second preliminary stack structure pST2 may include second sacrificial films 52, each including first semiconductor films 15 and second semiconductor films 25 that are stacked in the first direction DR1. The first semiconductor films 15 may be spaced apart in a second direction DR2, and the second sacrificial films 52 may also be spaced apart in the second direction DR2. The first sacrificial films 51 may be opposite to the second sacrificial films 52 in the third direction DR3. The first and second preliminary stack structures pST1 and pST2 may be symmetrical in the third direction DR3 with respect to an imaginary extension line extending in the first direction DR1 (e.g., a plane of symmetry extending in the first direction DR1 and the second direction DR2) between the first sacrificial films 51 and the second sacrificial films 52. For example, the first back gate lines BG1 and the second back gate lines BG2, the first semiconductor patterns SP1, the storage nodes SN, and the wordlines WL of the first preliminary stack structure pST1 may be symmetrical in the third direction DR3 with respect to the respective counterparts of the second preliminary stack structure pST2.

Referring to FIGS. 28A, 28B, and 7, the first sacrificial films 51 and the second sacrificial films 52 may be removed and bitlines BL may be formed in the spaces where the first sacrificial films 51 and the second sacrificial films 52 have been removed. Insulating layers extending in the first direction DR1 may be formed between the bitlines BL of the first preliminary stack structure pST1 and the bitlines BL of the second preliminary stack structure pST2. That is, the first semiconductor patterns SP1 and the second semiconductor patterns SP2, positioned between the bitlines BL of the first preliminary stack structure pST1 and the bitlines of the second preliminary stack structure pST2, may be removed. Accordingly, first and second stack structures ST1 and ST2, including sets of bitlines BL in opposite directions, may be formed simultaneously, as illustrated in FIG. 7. First preliminary stack structures pST1 and second preliminary stack structures pST2, which are alternately arranged in the third direction DR3, may be formed simultaneously, as illustrated in FIGS. 28A and 28B, resulting in the simultaneous formation of first stack structures ST1 and second stack structures ST2 that are alternately arranged in the third direction DR3, as illustrated in FIG. 7.

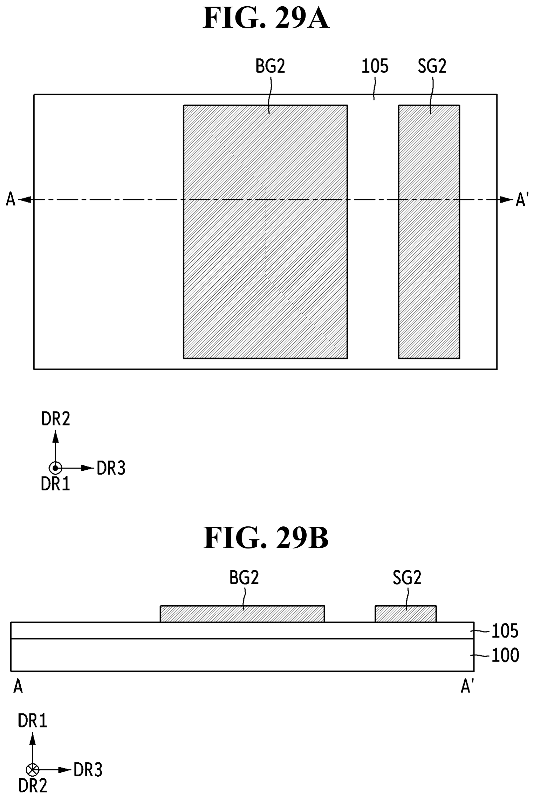

FIGS. 29A through 31A are plan views for explaining a method for manufacturing a semiconductor memory device according to some implementations. FIGS. 29B through 31B are cross-sectional views taken along lines A-A' of FIGS. 29A through 31A, respectively. For convenience, the following description will focus on differences from the implementations described with reference to FIGS. 1 through 28B.

Referring to FIGS. 29A and 29B, a second back gate line BG2 and a second shield gate line SG2 may be formed on a protective insulating layer 105 to be spaced apart in a third direction DR3. The second back gate line BG2 and the second shield gate line SG2 may extend in a first direction DR1.

For example, a mask pattern including two openings that expose portions of the upper surface of the protective insulating layer 105 may be formed on the protective insulating layer 105. A preliminary gate line may be formed on the mask pattern and the two openings, and the preliminary gate line on the mask pattern and the mask pattern may be removed, thereby forming the second back gate line BG2 and the second shield gate line SG2. In another example, a preliminary gate line may be formed on the protective insulating layer 105 and then patterned, thereby forming the second back gate line BG2 and the second shield gate line SG2.

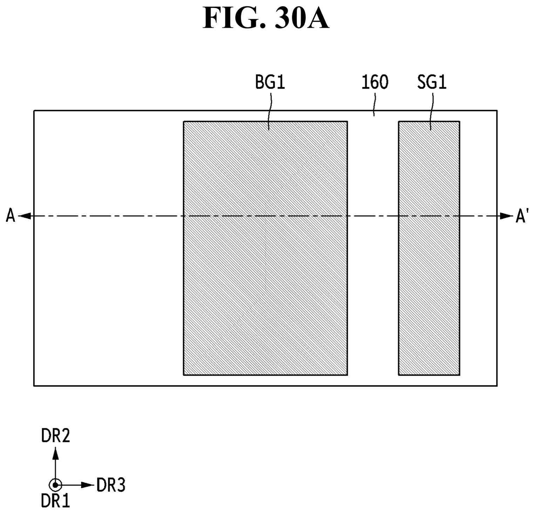

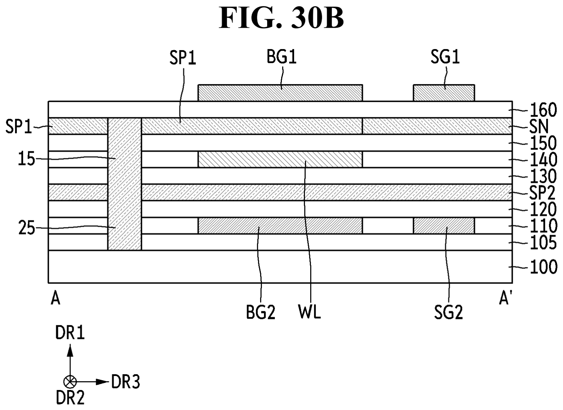

Referring to FIGS. 30A and 30B, a first insulating layer 110 surrounding the second back gate line BG2 and the second shield gate line SG2 may be formed. Thereafter, a second insulating layer 120 may be formed on the first insulating layer 110, the second back gate line BG2, and the second shield gate line SG2.

Thereafter, using the manufacturing processes illustrated in FIGS. 16A through 25B, second semiconductor patterns SP2, second semiconductor films 25, a third insulating layer 130, wordlines WL, a fourth insulating layer 140, fifth insulating layers 150, first semiconductor patterns SP1, storage nodes SN, and a sixth insulating layer 160 may be formed.

Thereafter, a first back gate line BG1 and a first shield gate line SG1 may be formed on the sixth insulating layer 160 to be spaced apart in the third direction DR3. The first back gate line BG1 and the first shield gate line SG1 may extend in the second direction DR3.

For example, a mask pattern including two openings that expose portions of the upper surface of the sixth insulating layer 160 may be formed on the sixth insulating layer 160. A preliminary gate line may be formed on the mask pattern and the two openings, and the preliminary gate line on the mask pattern and the mask pattern may be removed, thereby forming the first back gate line BG1 and the first shield gate line SG1. In another example, a preliminary gate line may be formed on the sixth insulating layer 160 and then patterned, thereby forming the first back gate line BG1 and the first shield gate line SG1.

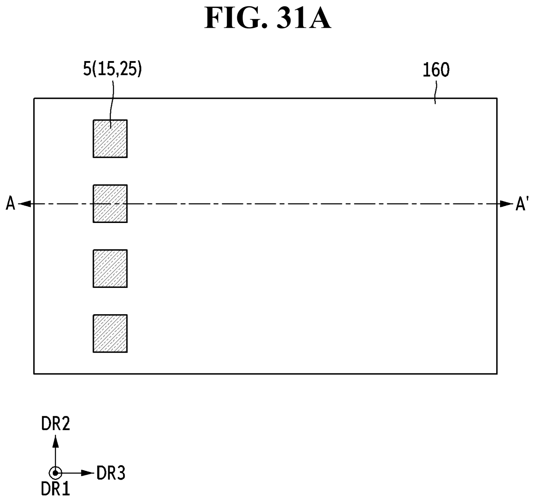

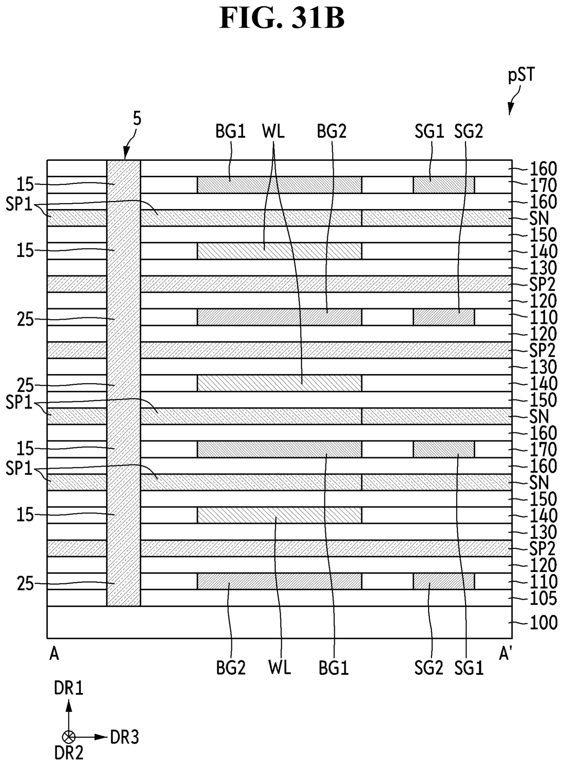

Referring to FIGS. 31A and 31B, a seventh insulating layer 170 surrounding the first back gate line BG1 and the first shield gate line SG1 may be formed.

Thereafter, using the manufacturing processes illustrated in FIGS. 29A through 31B, first insulating layers 110, second insulating layers 120, third insulating layers 130, fourth insulating layers 140, fifth insulating layers 150, sixth insulating layers 160, seventh insulating layers 170, second shield gate lines SG2, first semiconductor films 15, second semiconductor films 25, first semiconductor patterns SP1, and second semiconductor patterns SP2 may be further formed, thereby forming a preliminary stack structure pST. The preliminary stack structure pST may be symmetrical in the first direction DR1 with respect to the second back gate lines BG2 and the first insulating layers 110, and with respect to the first back gate lines BG1 and the seventh insulating layers 170.

Referring to FIGS. 31A, 31B, 9, and 10, the sacrificial films 5 may be removed and bitlines BL may be formed in the spaces where the sacrificial films 5 have been removed. Insulating layers extending in the third direction DR3 may be formed on second sides of the bitlines BL, where no memory cells MC are formed. Accordingly, stack structures ST, each including a plurality of memory cells MC, may be formed. FIGS. 9 and 10 may be diagrams in which the second sides of the bitlines BL in the third direction DR3 illustrated in FIGS. 31A and 31B are omitted.

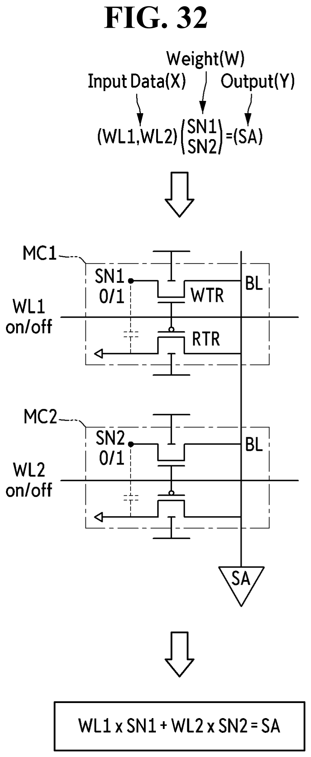

FIG. 32 is a diagram for explaining the operation of a semiconductor memory device according to some implementations.

Referring to FIG. 32, the semiconductor memory device according to some implementations may be configured to selectively perform a multiply-and-accumulate (MAC) operation according to an operation mode. The semiconductor memory device according to some implementations may correspond to any one of its counterparts described with reference to FIGS. 1 through 13.

For example, the semiconductor memory device according to some implementations may operate in a first operation mode as a processing-in-memory (PIM) device or in a second operation mode as a memory for a host device. The semiconductor memory device according to some implementations may operate in the first operation mode or the second operation mode in response to a mode selection signal from the host device.

In the first operation mode, the semiconductor memory device according to some implementations may perform a MAC operation. In the second operation mode, the semiconductor memory device may operate in a similar manner to a commonly used volatile memory device (e.g., as a random access memory device). In the second operation mode, the semiconductor memory device according to some implementations may operate as the main memory of the host device.

The first operation mode may be as follows. For example, the semiconductor memory device according to some implementations may include a first memory cell MC1 connected to a bitline BL and a first wordline WL1, a second memory cell MC2 connected to the bitline BL and a second wordline WL2, and a sense amplifier SA connected to the bitline BL. The sense amplifier SA may sense the voltage level of the bitline BL, which varies according to the on/off state of the first and second wordlines WL1 and WL2 and data values stored in first and second storage nodes SN1 and SN2, and may perform a weighted sum operation. The sense amplifier SA may generate output data Y, which is a weighted sum based on input data X for the on/off states of the first and second wordlines WL1 and WL2 and on a weight W for the data values stored in the first and second storage nodes SN1 and SN2. If the first and second wordlines WL1 and WL2 are on, the input data X may be 1, and if the first and second wordlines WL1 and WL2 are off, the input data X may be 0. The off state of the first and second wordlines WL1 and WL2 may correspond to a state when a logic high voltage is applied to the first and second wordlines WL1 and WL2, turning off read transistors RTR. The on state of the first and second wordlines WL1 and WL2 may correspond to a state when a logic low voltage is applied to the wordlines WL1 and WL2, turning on the read transistors RTR. If the data values stored in the first and second storage nodes SN1 and SN2 are 0, the weight W may be 0, and if the data values stored in the storage nodes SN1 and SN2 are 1, the weight W may be 1.

The semiconductor memory device according to some implementations may perform a read operation on the first and second memory cells MC1 and MC2, thereby performing a continuous MAC operation. For example, the semiconductor memory device according to some implementations may perform a read operation on the first memory cell MC1, a read operation on the second memory cell MC2, and then a read operation on both the first and second memory cells MC1 and MC2 consecutively to execute a continuous MAC operation.

As used herein, numerical labels, such as "first", "second", "third", etc. may be used to simply distinguish a corresponding component from another, and do not limit the components in other aspect (e.g., importance or order).

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The terms "upper", "middle", "lower", "above", "below", etc. may refer to relative positions along a particular direction (e.g. a vertical direction). Various directions (e.g. vertical direction, horizontal direction, etc.) may be defined relative to the structure of the devices described herein (e.g., relative to the substrate). For instance, a vertical direction may be defined perpendicular to the upper surface of the substrate. A horizontal direction may be defined parallel to the upper surface of the substrate. It will be appreciated that these directions do not necessarily imply any particular orientation of the device in use. In addition, the term "on" may refer to a component that is above or below another component. That is, a first component that is "on" a second component, may above or below the second component, (e.g., may be adjacent to the second component in the vertical direction). When an element or layer is referred to as being "over", "above", "on", "below", "under", "beneath", etc. it can be directly over, above, on, below, under, or beneath, the other element or layer or intervening elements or layers may be present. In contrast, when an element is referred to as being "directly over", "directly above", "directly on", "directly below", "directly under" or "directly beneath" another element or layer, there are no intervening elements or layers present.

The term "overlap" (or "overlapping", or like terms), as may be used herein, is intended to broadly refer to a first element that intersects with at least a portion of a second element in the vertical direction, but does not require that the first and second elements be completely aligned with one another in a horizontal plane. That is, components or layers described with reference to "overlap" in a particular direction may be at least partially obstructed by one another when viewed along a line extending in the particular direction.

Although the implementations of the present disclosure have been described with reference to the accompanying drawings, the present disclosure is not limited to these implementations and may be manufactured in various other forms. Those skilled in the art will understand that the technical scope or essential characteristics of the present disclosure can be modified and implemented in other specific forms without departing from the scope of the invention. Therefore, the implementations described above should be understood as being illustrative in all respects and not limiting.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following Clauses:
Clause 1. A semiconductor memory device comprising:
   a substrate;
   first back gate lines and second back gate lines alternately arranged in a first direction on the substrate, the first back gate lines being to be spaced apart from the second back gate lines;
   wordlines , each positioned being between corresponding first and second back gate lines that are adjacent in the first direction;
   bitlines extending in the first direction on the substrate;
   first semiconductor patterns connected to the bitlines, and each of the first semiconductor patterns positioned being between a corresponding first back gate line of the first back gate lines and a corresponding wordline of the wordlines that are adjacent in the first direction;
   storage nodes connected to the first semiconductor patterns; and
   second semiconductor patterns connected to the bitlines, and each of the second semiconductor patterns positioned being between a corresponding wordline of the wordlines and a corresponding second back gate line of the second back gate lines that are adjacent in the first direction.
Clause 2. The semiconductor memory device of Clause 1, wherein
   the first back gate lines, the second back gate lines, and the wordlines extend in a second direction,
   the first semiconductor patterns and the second semiconductor patterns extend in a third direction,
   the first direction is perpendicular to an upper surface of the substrate, and
   the second and third directions are parallel to the upper surface of the substrate.
Clause 3. The semiconductor memory device of Clause 1 or Clause 2, wherein
   the first back gate lines, the second back gate lines, and the wordlines extend in a second direction,
   the first semiconductor patterns and the second semiconductor patterns extend in a third direction,
   the third direction is perpendicular to an upper surface of the substrate, and
   the first and second directions are parallel to the upper surface of the substrate.
Clause 4. The semiconductor memory device of any preceding Clause, further comprising:
   first shield gate lines spaced apart from the respective first back gate lines in the a third direction, the first shield gate lines and overlapping the storage nodes in the first direction; and
   second shield gate lines spaced apart from the respective second back gate lines in the third direction and, the second shield gate lines overlapping the second semiconductor patterns in the first direction.
Clause 5. The semiconductor memory device of any preceding Clause, wherein
   the bitlines, the first back gate lines, the first semiconductor patterns, the wordlines, the second semiconductor patterns, and the second back gate lines form stack structures,
   the stack structures include a first stack structure and a second stack structure adjacent to each other, and
   the first and second stack structures are symmetrical with respect to a linean axis extending in the first direction between the first and second stack structures.
Clause 6. The semiconductor memory device of any preceding Clause, wherein the first back gate lines, the second back gate lines, and the wordlines overlap in the first direction.
Clause 7. A semiconductor memory device comprising:
   a substrate;
   first back gate lines and second back gate lines alternately arranged in the a first direction on the substrate, the first back gate lines being to be spaced apart from the second back gate lines, and the first back gate lines and the second back gate lines extending in a second direction;
   wordlines extending in the second direction, and each of the wordlines positioned being between a corresponding first back gate line of the first back gate lines and a corresponding second back gate line of the second back gate lines that are adjacent in the first direction;
   bitlines extending in the first direction and being spaced apart in the second direction on the substrate;
   first semiconductor patterns connected to the respective bitlines, each of the first semiconductor patterns positioned being between a corresponding first back gate line of the first back gate lines and a corresponding wordline of the wordlines that are adjacent in the first direction, and the first semiconductor patterns extending in a third direction; and
   second semiconductor patterns connected to the respective bitlines, each of the second semiconductor patterns being positioned between a corresponding wordline of the wordlines and a corresponding second back gate line of the second back gate lines that are adjacent in the first direction, and the second semiconductor patterns extending in the third direction,
   wherein
   the first, second, and third directions intersect each other, and
   wherein one of the first, second, and third directions is perpendicular to an upper surface of the substrate.
Clause 8. The semiconductor memory device of Clause 7, wherein the first semiconductor patterns and the second semiconductor patterns include epitaxial silicon.

## Claims

1. A semiconductor memory device comprising:
a substrate (100);
bitlines (BL) extending in a first direction on the substrate (100);
first back gate lines (BG1) extending in a second direction;
first semiconductor patterns (SP1) connected to the bitlines (BL), the first semiconductor patterns (SP1) extending in a third direction and being on the first back gate lines (BG1);
wordlines (WL) extending in the second direction on the first semiconductor patterns (SP1);
second semiconductor patterns (SP2) connected to the bitlines (BL), the second semiconductor patterns (SP2) extending in the third direction and being on the wordlines (WL); and
second back gate lines (BG2) extending in the second direction on the second semiconductor patterns (SP2).

2. The semiconductor memory device of claim 1, wherein the wordlines (WL) overlap the first back gate lines (BG1) and the second back gate lines (BG2) in the first direction.

3. The semiconductor memory device of claim 1 or claim 2, wherein
the first direction is perpendicular to an upper surface of the substrate (100), and
the second and third directions are parallel to the upper surface of the substrate (100).

4. The semiconductor memory device of claim 3, wherein the second direction intersects the third direction.

5. The semiconductor memory device of claim 1 or claim 2, wherein
the third direction is perpendicular to an upper surface of the substrate (100), and
the first and second directions are parallel to the upper surface of the substrate (100).

6. The semiconductor memory device of claim 5, wherein the first direction intersects the second direction.

7. The semiconductor memory device of any preceding claim, wherein
the bitlines (BL), the first back gate lines (BG1), the first semiconductor patterns (SP1), the wordlines (WL), the second semiconductor patterns (SP2), and the second back gate lines (BG2) form stack structures (ST),
the stack structures (ST) include a first stack structure (ST1) and a second stack (ST2) structure adjacent in the third direction, and
the first and second stack structures (ST1, ST2) are symmetrical with respect to an axis extending in the first direction between the first and second stack structures (ST1, ST2).

8. The semiconductor memory device of any preceding claim, wherein
the bitlines (BL) are spaced apart in the second direction,
the first semiconductor patterns (SP1) are spaced apart in the second direction, are connected to the respective bitlines (BL), and overlap the first back gate lines (BG1) and the wordlines (WL) in the first direction, and
the second semiconductor patterns (SP2) are spaced apart in the second direction, are connected to the respective bitlines (BL), and overlap the wordlines (WL) and the second back gate lines (BG2) in the first direction.

9. The semiconductor memory device of any preceding claim, comprising:
storage nodes (SN) connected to the first semiconductor patterns (SP1);
first shield gate lines (SG1) spaced apart from the first back gate lines (BG1) in the third direction on the storage nodes (SN); and
second shield gate lines (SG2) spaced apart from the second back gate lines (BG2) in the third direction on the second semiconductor patterns (SP2).

10. The semiconductor memory device of claim 9, wherein
the first shield gate lines (SG1) overlap the storage nodes (SN) in the first direction, and
the second shield gate lines (SG2) overlap the second semiconductor patterns (SP2) in the first direction.

11. The semiconductor memory device of claim 9 or claim 10, wherein the first shield gate lines (SG1) and the second shield gate lines (SG2) overlap in the first direction.

12. The semiconductor memory device of any of claims 9-11, wherein
the first shield gate lines (SG1) and the second shield gate lines (SG2) extend in the second direction,
the bitlines (BL) are spaced apart in the second direction,
the first semiconductor patterns (SP1) are spaced apart in the second direction, are connected to the respective bitlines (BL),
the second semiconductor patterns (SP2) are spaced apart in the second direction, are connected to the respective bitlines (BL), and overlap the first shield gate lines (SG1) in the first direction, and
the storage nodes (SN) are spaced apart in the second direction, are connected to the respective first semiconductor patterns (SP1), and overlap the second shield gate lines (SG2) in the first direction.

13. The semiconductor memory device of any preceding claim, wherein the first semiconductor patterns (SP1) and the second semiconductor patterns (SP2) include epitaxial silicon.

14. The semiconductor memory device of any preceding claim, wherein
the first semiconductor patterns (SP1) include impurities of a first conductivity type, and
the second semiconductor patterns (SP2) include impurities of a second conductivity type different from the first conductivity type.

15. The semiconductor memory device of any preceding claim, wherein:
the first back gate lines (BG1) and second back gate lines (BG2) are alternately arranged on the substrate (100) in the first direction, the first back gate lines (BG1) being spaced apart from the second back gate lines (BG2);
each wordline (WL)is positioned between corresponding first and second back gate lines (BG1, BG2) that are adjacent in the first direction;
each of the first semiconductor patterns (SP1) is positioned between a corresponding first back gate line (BG1) of the first back gate lines (BG1) and a corresponding wordline (WL) of the wordlines (WL) that are adjacent in the first direction;
the semiconductor memory device further comprises storage nodes (SN) connected to the first semiconductor patterns (SP1); and
each of the second semiconductor patterns (SP2) is positioned between a corresponding wordline (WL) of the wordlines (WL) and a corresponding second back gate line (BG2) of the second back gate lines (BG2) that are adjacent in the first direction.
